(19)

Europäisches
Patentamt
European
Patent Office
Office européen
des brevets

(11)     **EP 2 420 851 A1**

(12)     **EUROPEAN PATENT APPLICATION**
published in accordance with Art. 153(4) EPC

(43) Date of publication:
**22.02.2012 Bulletin 2012/08**

(21) Application number: **10764485.8**

(22) Date of filing: **14.04.2010**

(51) Int Cl.:
*G01R 31/00* (2006.01)     *G01R 31/02* (2006.01)

(86) International application number:
**PCT/JP2010/056701**

(87) International publication number:
**WO 2010/119901 (21.10.2010 Gazette 2010/42)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **15.04.2009 PCT/JP2009/057606**

(71) Applicant: **Bosch Corporation
Tokyo 150-8360 (JP)**

(72) Inventors:
 • **SY, Williamson
   Yokohama-shi
   Kanagawa 224-8501 (JP)**
 • **TAJIRI, Daichi
   Matsuyama-shi
   Saitama 355-8603 (JP)**
 • **YURUE, Kenji
   Yokohama-shi
   Kanagawa 224-8501 (JP)**
 • **KURITA, Yasuaki
   Yokohama-shi
   Kanagawa 224-8501 (JP)**
 • **STEGMAIER, Juergen
   70469 Stuttgart-Feuerbach (DE)**

 • **ABU WHISHAH, Mustafa
   72762 Reutlingen (DE)**
 • **AKITA, Takeo
   Yokohama-shi
   Kanagawa 224-8501 (JP)**
 • **TAKASAKI, Minoru
   Yokohama-shi
   Kanagawa 224-8501 (JP)**
 • **HASEGAWA, Tohru
   Yokohama-shi
   Kanagawa 224-8501 (JP)**
 • **OKADA, Takuya
   Yokohama-shi
   Kanagawa 224-8501 (JP)**
 • **HITOMI, Isamu
   Yokohama-shi
   Kanagawa
   2248501 (JP)**

(74) Representative: **Dreiss
Patentanwälte
Postfach 10 37 62
70032 Stuttgart (DE)**

(54)     **ABNORMALITY DETECTION DEVICE FOR DETECTION CIRCUIT AND ELECTRIC CIRCUIT,
AND DETECTION SYSTEM AND ELECTRONIC SYSTEM USING THE ABNORMALITY
DETECTION DEVICE**

(57)     In an electric circuit whose behavior is changed corresponding to a peripheral environment, an abnormality detection device can surely detect abnormality in the electric circuit even in a state where a value of the peripheral environment cannot be specified. An abnormality detection device according to the present invention detects abnormality in a detection circuit (112) which detects a specific kind of physical quantity. The abnormality detection device includes an abnormality detection part (220a) which changes magnitude of a power source voltage ($Vcc'$) which is supplied to the detection circuit (112), and detects abnormality in the detection circuit based on an output signal ($Vo2$) from the detection circuit at a power source voltage ($Vc2$) after the change.

Fig. 14

EP 2 420 851 A1

**Description**

TECHNICAL FIELD

The present invention relates to an abnormality detection device for detecting abnormality in an electric circuit, and more particularly abnormality in a detection circuit, and a detection system or an electronic system which uses the abnormality detection device.

BACKGROUND ART

There has been known a detection system which detects a pressure of a negative pressure booster which assists a braking force of a braking device (brake) of a vehicle. The detection system is constituted of a pressure sensor which detects a negative booster pressure and a processing device (for example, ECU) which processes an output from the pressure sensor. In such a detection system, there may be a case where even when abnormality exists in a sensor circuit, a detection signal level falls within a normal range thus giving rise to a case where the detection of abnormality in the sensor circuit is difficult. As a method of detecting abnormality in a sensor circuit, there has been proposed a technique which uses test pulses described in patent documents 1 and 2.

Patent document 1 discloses a brake system which executes an antilock operation of a vehicle using a detected value of a vehicle speed sensor, wherein when the detected value of the vehicle speed sensor indicates a value less than a predetermined value, a defect of an electric circuit including the vehicle speed sensor is detected. In the system, a vehicle speed sensor 18 is connected to a sensor signal condition imparting circuit 36 through an electric circuit 22, and the sensor signal condition imparting circuit 36 outputs a signal to a microprocessor 37 when a value of a detection signal from the vehicle speed sensor 18 exceeds a predetermined value. The electric circuit 22 includes two signal lines which connect two terminals on an output side of the vehicle speed sensor 18 and two terminals on an input side of the sensor signal condition imparting circuit 36, and input impedance 35 which is connected between these two signal lines. In the system, when an output of the sensor signal condition imparting circuit 36 becomes 0, a DC current (test pulse) is supplied between two signal lines of the electric circuit 22 from a conduction test circuit 38 thus performing a conduction test of the sensor 18 or the electric circuit 22. When the sensor 18 or the electric circuit 22 is conductive (normal), a relatively small voltage step-down occurs between both terminals of an input of the sensor signal condition imparting circuit 36 and there is no output from the sensor signal condition imparting circuit 36. On the other hand, when the sensor 18 or the electric circuit 22 is not conductive (abnormal), impedance viewed from the conduction test circuit 38 is high so that a voltage step-down of a predetermined value or more occurs between both terminals of an input of the sensor signal condition imparting circuit 36 whereby an output is generated from the sensor signal condition imparting circuit 36. Accordingly, in this system, a test pulse is supplied between two signal lines of the electric circuit 22, wherein it is determined that the sensor 18 or the electric circuit 22 is in a normal state when the output of the sensor signal condition imparting circuit 36 is 0, while the sensor 18 or the electric circuit 22 is in an abnormal state when the output of the sensor signal condition imparting circuit 36 is not 0.

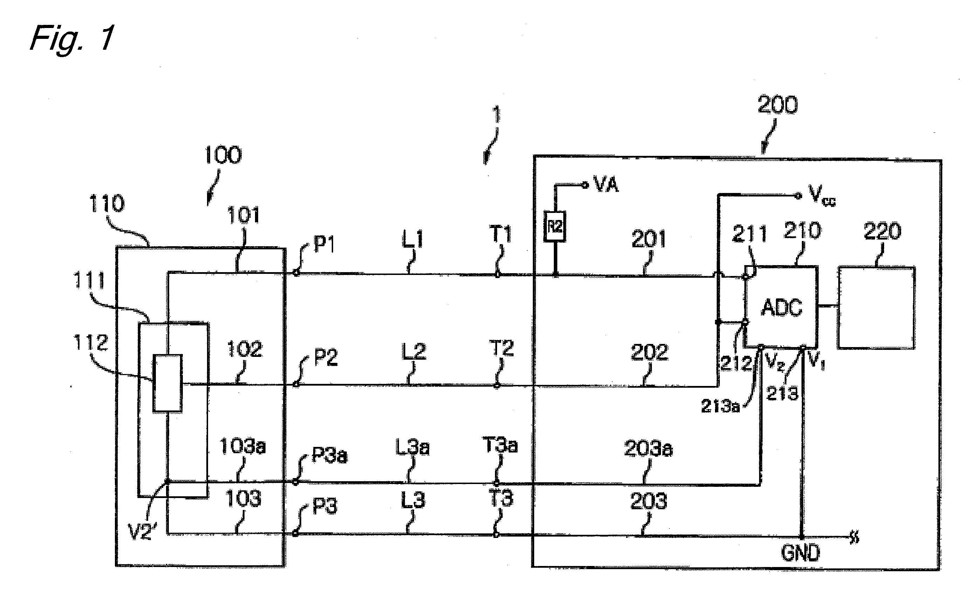

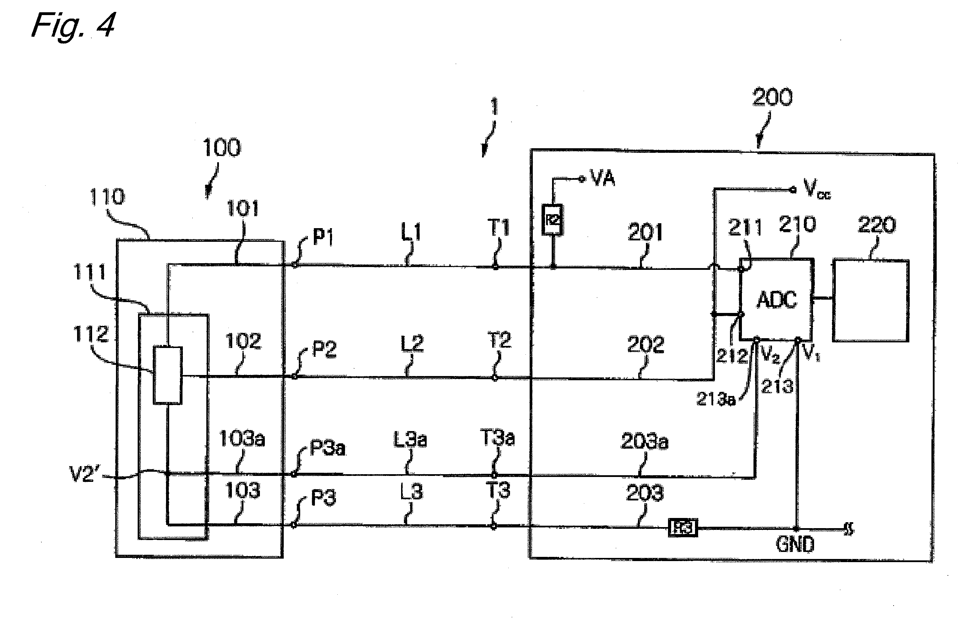

Patent document 2 relates to a diagnosis device which diagnoses a failure of an electric system of an automobile. With respect to this diagnosis device, there is described a device which diagnoses abnormality in parts which are subject to diagnosis by outputting a test pulse signal to the part which is subject to diagnosis from a pulse generator (see Fig. 4) and by detecting a response of the part which is subject to diagnosis to the test pulse (see Fig. 1).

PRIOR ART DOCUMENT

PATENT DOCUMENT

   Patent document 1: JP-T-5-503779
   Patent document 2: JP-A-4-231838

SUMMARY OF THE INVENTION

PROBLEM THAT THE INVENTION IS TO SOLVE

However, in the pressure detection system for the negative pressure booster, there may be a case where a residual pressure remains even when an engine is stopped and hence, a pressure value cannot be specified whereby a sensor circuit output which becomes a determination standard cannot be specified. Accordingly, unlike the devices disclosed in the patent documents 1 and 2, the pressure detection system for the negative pressure booster cannot detect abnormality in a sensor circuit using a test pulse.

On the other hand, in the method described in patent documents 1 and 2, additional parts for a circuit which generates a test pulse, a circuit which evaluates an output based on the test pulse and the like become necessary thus giving rise to a possibility that a cost is pushed up.

It is an object of the present invention to provide, in an electric circuit whose behavior is changed corresponding to a peripheral environment, a technique which can surely detect abnormality in an electric circuit even in a state where a value of the peripheral environment cannot be specified.

It is also another object of the present invention to provide a technique which can easily and surely detect abnormality in an electric circuit whose behavior is changed corresponding to a peripheral environment.

MEANS FOR SOLVING THE PROBLEM

One mode for carrying out the present invention relates to an abnormality detection device which detects abnormality in a detection circuit (112) which detects a specific kind of physical quantity. The abnormality detection device includes an abnormality detection part (220a) which changes magnitude of a power source voltage (Vcc') which is supplied to the detection circuit (112), and detects abnormality in the detection circuit based on an output signal (Vo2) from the detection circuit at a power source voltage (Vc2) after the change of the magnitude of the power source voltage (Vcc'). Here, specific kinds of physical quantities include values of pressure, temperature, speed, acceleration and humidity. However, the physical quantities are not limited to these physical quantities.

The abnormality detection device for the detection circuit (112) can detect the abnormality in the detection circuit by changing the magnitude of the power source voltage which is supplied to the detection circuit and by determining whether or not the output signal (Vo2) of the detection circuit with respect to the power source voltage (Vc2) after the change conforms to predetermined input/output characteristic. That is, even when the current physical quantity is unknown, provided that the input/output characteristic of the detection circuit is known in advance, the abnormality in the detection circuit can be detected. Here, the input/output characteristic is the relationship between input/output values of the detection circuit, and means the relationship between the power source voltage (input) and an output signal.

In one mode for carrying out the present invention, the abnormality detection part (220a) detects the abnormality in the detection circuit (112) based on whether or not output signals (Vo1, Vo2) from the detection circuit (112) before and after the change of the power source voltage are on an input/output characteristic curve with respect to the same physical quantity (P).

In this case, the abnormality detection part (220a) obtains and stores input/output characteristic curves corresponding to respective physical quantities in advance, detects the output signals (Vo1, Vo2) of the detection circuit (112) before and after the change of the power source voltage within a short time which does not cause a change of the physical quantities, determines that the detection circuit is in a normal state when the output signals (Vo1, Vo2) are on an input/output characteristic curve with respect to the same physical quantity and determines that the detection circuit is in an abnormal state when the output signals (Vo1, Vo2) are not on the input/output characteristic curve with respect to the same physical quantity. In a state where the input/output characteristic curve of the detection circuit can be calculated, when the input/output characteristic is calculated during abnormality detection processing, it is unnecessary for the abnormality detection part (220a) to store input/output characteristic curves corresponding to respective physical quantities in advance. When the input/output characteristic of the detection circuit is formed of a straight line, it is unnecessary for the abnormality detection part (220a) to store input/output characteristic curves corresponding to respective physical quantities in advance, and the abnormality detection part (220a) also can detect abnormality in the detection circuit based on whether or not a ratio of output signals before and after the change agrees with a ratio of input signals before and after the change.

In one mode for carrying out the present invention, the abnormality detection part (220a) detects the abnormality in the detection circuit (112) based on whether or not the ratio of output signals (Vo1, Vo2) from the detection circuit (112) before and after the change of the power source voltage agrees with the ratio of power source voltages (Vc1, Vc2) before and after the change of the power source voltage. When the input/output characteristic of the detection circuit is formed of a straight line, the abnormality detection part (220a) can detect the abnormality in the detection circuit based on whether or not a ratio of output signals before and after the change agrees with a ratio of input signals before and after the change.

In one mode for carrying out the present invention, the abnormality detection part (220a) changes the power source voltage to a plurality of voltages (Vc2, Vc3) which differ from each other, and detects the abnormality in the detection circuit (112) based on output signals (Vo2, Vo3) from the detection circuit (112) at the plurality of power source voltages (Vc2, Vc3) after the change.

In such a mode for carrying out the invention, the abnormality detection part (220a) can detect the abnormality in the detection circuit by determining whether or not the output signals (Vo2, Vo3) at the plurality of power source voltages (Vc2, Vc3) after the change conform to the predetermined input/output characteristic. Further, the abnormality detection part (220a) may determine whether or not output signals (Vo1, Vo2, Vo3) corresponding to three or more kinds of power source voltages (Vc1, Vc2, Vc3) including the power source voltage (Vcc) before the change and a plurality of power source voltages (Vc2, Vc3) after the change conform to the predetermined input/output characteristic. In this case, when the input/output characteristic is formed of a curve, the abnormality detection part (220a) can determine with high accuracy whether or not the output signal conforms to the predetermined input/output characteristic.

In one mode for carrying out the present invention, the abnormality detection part (220a) measures an output signal from the detection circuit (112) with respect to the power source voltage value (Vc1) before the change at least twice at a predetermined time interval, and when the output signals (Vo1, Vo1') agree with each other at least twice, the abnormality detection part (220a) detects the abnormality in the detection circuit based on the output signal (Vo2) from the detection circuit at the power source voltage (Vc2) after the change. The abnormality detection part (220a) determines whether or not the detection circuit is in a situation where a physical quantity which is an object to be detected is not changed within a short time based on whether or not the plurality of measured values of the output signal with respect to the power source voltage value (Vc1) before the change agree with each other, and executes the abnormality detection processing in the situation where the physical quantity is not changed within the short time.

In one mode for carrying out the present invention, the abnormality detection device includes a power source voltage control part (230) which changes magnitude of a power source voltage (Vcc') which is supplied to the detection circuit (112) in response to a control by the abnormality detection part (220a). For example, the detection of abnormality in the detection circuit can be surely performed with the simple constitution by simply adding the power source voltage control part consisting of a resistance and a switch.

In one mode for carrying out the present invention, the detection circuit (112) is a pressure sensor which detects pressure in a negative pressure booster which assists a braking device of a vehicle. There may be a case where a residual pressure remains in the inside of the negative pressure booster even after an engine is stopped. In this case, a pressure value cannot be determined. Accordingly, in a conventional method which uses a test pulse, abnormality in the pressure sensor cannot be detected. To the contrary, according to the present invention, even when a pressure value at the time of diagnosis is unknown, provided that an input/output characteristic of the detection circuit is known in advance, abnormality in the detection circuit can be detected.

One mode for carrying out the present invention relates to an abnormality detection device which detects abnormality in the electric circuit (112) whose behavior is changed corresponding to a peripheral environment. The abnormality detection device includes an abnormality detection part (220a) which changes magnitude of a power source voltage (Vcc') supplied to the electric circuit (112), and detects abnormality in the electric circuit based on the behavior (Vo2) of the electric circuit at a power source voltage (Vc2) after the change. Here, the peripheral environment means a state such as pressure, temperature, speed, acceleration, temperature or humidity around the electric circuit.

One mode for carrying out the present invention relates to a detection system. The detection system includes a detection circuit (112) which detects a specific kind of physical quantity, a processing device (200) which processes an output from the detection circuit (112), conductive lines (L1, 101; L2, 102; L3, 103) which electrically connect the detection circuit and the processing device, and monitoring conductive lines (L1a, 101a; L2a, 102a; L3a, 103a) which are electrically connected with the conductive lines on the detection circuit (112) side, wherein a resistance state of the conductive line is detected by detecting a potential at a connection point between the conductive line and the monitoring conductive line using the monitoring conductive line. Further, the detection system includes an abnormality detection part (220a) which changes magnitude of a power source voltage (Vcc') supplied to the detection circuit (112), and detects abnormality in the detection circuit (112) based on an output signal (Vo2) from the detection circuit at a power source voltage (Vc2) after the change.

One mode for carrying out the present invention relates to an electronic system. The electronic system includes a first electric circuit (112) whose behavior is changed corresponding to a peripheral environment, a second electric circuit (200), conductive lines (L1, 101; L2, 102; L3, 103) which are electrically connected between the first electric circuit and the second electric circuit, and monitoring signal lines (L1a, 101a; L2a, 102a; L3a, 103a) which are electrically connected to the conductive lines on the first electric circuit side, wherein a resistance state of the conductive line is detected by detecting a potential at a connection point between the conductive line and the monitoring signal line through the monitoring signal line. Further, the electronic system includes an abnormality detection part (220a) which changes magnitude of a power source voltage (Vcc') supplied to the first electric circuit (112), and detects abnormality in the first electric circuit (112) based on the behavior (Vo2) of the first electric circuit at a power source voltage (Vc2) after the change.

In one mode for carrying out the present invention, an abnormality detection device for a detection circuit (112) which includes a detection part (151) for detecting a specific kind of physical quantity includes an abnormality detection part (220b) which changes magnitude of a power source voltage (Vcc') supplied to the detection circuit (112), detects an output signal (Vout) of the detection circuit (112) when the power source voltage (Vcc') is less than the power source voltage (Vx) at which the detection part (151) is stopped, and detects abnormality in the detection circuit (112) based on the detected value.

In one mode for carrying out the present invention, the abnormality detection part (220b), further, detects a resistance state of a conductive line which connects the detection circuit (112) with the outside based on the power source voltage (Vx) at which the detection part (151) is stopped.

In one mode for carrying out the present invention, an abnormality detection device for a detection circuit (112) including a detection part (151) which detects a specific kind of physical quantity includes an abnormality detection part (220b) which changes magnitude of a power source voltage (Vcc') supplied to the detection circuit (112), detects the power source voltage (Vx) at which the detection part (151) is stopped, and detects a resistance state of a conductive line which connects the detection circuit (112) with the outside based on the detected value.

In one mode for carrying out the present invention, an abnormality detection device for an electric circuit (112) includes an abnormality detection part (220b) which changes magnitude of a power source voltage (Vcc') supplied to the electric circuit (112), detects an output signal (Vout) of the electric circuit (112) when the power source voltage (Vcc') is less than the power source voltage (Vx) at which a portion (151) included in the electric circuit (112) is stopped, and detects abnormality in the electric circuit (112) based on the detected value.

In one mode for carrying out the present invention, an abnormality detection device for an electric circuit (112) includes an abnormality detection part (220b) which changes magnitude of a power source voltage (Vcc') supplied to the electric circuit (112), detects the power source voltage (Vx) at which a portion (151) of the electric circuit (112) is stopped, and detects a resistance state of a conductive line which connects the electric circuit (112) with the outside based on the detected value.

In one mode for carrying out the present invention, an abnormality detection device for a detection circuit (112) which includes a detection part (151) for detecting a specific kind of physical quantity includes a first abnormality detection part (220a) and a second abnormality detection part (220b). The first abnormality detection part (220a) changes magnitude of a power source voltage (Vcc') supplied to the detection circuit (112), detects an output signal (Vo2) from the detection circuit with respect to a power source voltage (Vc2) after the change within a range of not less than the power source voltage (Vx) at which the detection part (151) is stopped, and detects abnormality in the detection circuit based on the detected value. The second abnormality detection part (220b) detects the power source voltage (Vx) at which the detection part (151) is stopped, and detects a resistance state of a conductive line which connects the detection circuit (112) with the outside based on the detected value.

In one mode for carrying out the present invention, an abnormality detection device which detects abnormality in an electric circuit (112) including a circuit part (151) whose behavior is changed corresponding to a peripheral environment includes a first abnormality detection part (220a) and a second abnormality detection part (220b). The first abnormality detection part (220a) changes magnitude of a power source voltage (Vcc') supplied to the electric circuit (112), detects an output signal (Vo2) from the detection circuit with respect to a power source voltage (Vc2) after the change within a range not less than the power source voltage (Vx) at which the circuit part (151) is stopped, and detects abnormality in the electric circuit based on the detected value. The second abnormality detection part (220b) detects the power source voltage (Vx) at which the circuit part (151) is stopped, and detects a resistance state of a conductive line which connects the electric circuit (112) with the outside based on the detected value.

One mode for carrying out the present invention relates to a detection system. The detection system includes a detection circuit (112) including a detection part (151) which detects a specific kind of physical quantity, a processing device (200) which processes an output from the detection circuit (112), a conductive line (L1, 101; L2, 102; L3, 103) which electrically connects the detection circuit and the processing device, and a monitoring conductive line (L1a, 101a; L2a, 102a; L3a, 103a) which is electrically connected with the conductive line on the detection circuit (112) side, wherein a resistance state of the conductive line is detected by detecting a potential at a connection point between the conductive line and the monitoring conductive line through the monitoring conductive line. Further, the detection system further includes an abnormality detection part (220b) which changes magnitude of a power source voltage (Vcc') supplied to the detection circuit (112), detects an output signal (Vout) of the detection circuit (112) when the power source voltage (Vcc') is less than the power source voltage (Vx) at which the detection part (151) is stopped, and detects abnormality in the detection circuit (112) based on the detected value.

One mode for carrying out the present invention relates to an electronic system. The electronic system includes a first electric circuit (112), a second electric circuit (200), a conductive line (L1, 101; L2, 102; L3, 103) which electrically connects the first electric circuit and the second electric circuit, and a monitoring signal line (L1a, 101a; L2a, 102a; L3a, 103a) which is electrically connected to the conductive line on the first electric circuit side, wherein a resistance state of the conductive line is detected by detecting a potential at a connection point between the conductive line and the monitoring signal line through the monitoring signal line. Further, the electronic system includes an abnormality detection part (220b) which changes magnitude of a power source voltage (Vcc') supplied to the electric circuit (112), detects an output signal (Vout) of the electric circuit (112) when the power source voltage (Vcc')is less than a stop power source voltage (Vx) at which a part (151) of the electric circuit is stopped, and detects abnormality in the electric circuit (112) based on the detected value.

In one mode for carrying out the present invention, an abnormality detection device for a detection circuit (112) which including a detection part (151) for detecting a specific kind of physical quantity includes a first abnormality detection part (220a) and a second abnormality detection part (220b). The first abnormality detection part (220a) changes magnitude of a power source voltage (Vcc') supplied to the detection circuit (112), detects an output signal (Vo2) from the detection circuit with respect to a power source voltage (Vc2) after the change within a range not less than the power source voltage (Vx) at which the detection part (151) is stopped, and detects abnormality in the detection circuit based on the detected value. The second abnormality detection part (220b) detects an output signal (Vout) of the detection circuit (112) when the power source voltage (Vcc') is less than the power source voltage (Vx) at which the detection part (151) is stopped, and detects abnormality in the detection circuit (112) based on the detected value.

In one mode for carrying out the present invention, an abnormality detection device which detects abnormality in an electric circuit (112) including a circuit part (151) whose behavior is changed corresponding to a peripheral environment includes a first abnormality detection part (220a) and a second abnormality detection part (220b). The first abnormality detection part (220a) changes magnitude of a power source voltage (Vcc') supplied to the electric circuit (112), detects an output signal (Vo2) from the detection circuit with respect to a power source voltage (Vc2) after the change within a range not less than the power source voltage (Vx) at which the circuit part (151) is stopped, and detects abnormality in the electric circuit based on the detected value. The second abnormality detection part (220b) detects an output signal (Vout) of the electric circuit (112) when the power source voltage (Vcc') is less than the stop power source voltage (Vx) at which the portion (151) of the electric circuit is stopped, and detects abnormality in the electric circuit (112) based on the detected value.

In one mode for carrying out the present invention, an electric system includes a first electric circuit (112), a ground line (L3, 103) which is connected to a ground terminal of the first electric circuit (112), and a monitoring conductive line (L3a, 103a) which is electrically connected to the ground line and detects a potential (V2') at a connection point with the ground line, and corrects a behavior (Vout) of the first electric circuit (112) based on a detection voltage (V2) through the monitoring conductive line.

In one mode for carrying out the present invention, the monitoring conductive line (L3a, 103a) is connected to a power source voltage (Vcc) through a first resistance (R5), and is also connected to a ground potential (GND) through a second resistance (R6), and detects abnormality in the monitoring conductive line per se by detecting a voltage of the second resistance as the detection voltage (V2).

In one mode for carrying out the present invention, when the detection voltage (V2) through the monitoring conductive line is smaller than a first threshold value, the correction of the behavior (Vout) of the first electric circuit (112) is executed using the detection voltage (V2) through the monitoring conductive line, and it is determined that the monitoring conductive line is disconnected when the detection voltage (V2) through the monitoring conductive line becomes the first threshold value or more.

In one mode for carrying out the present invention, when the detection voltage (V2) through the monitoring conductive line is smaller than a second threshold value which is smaller than the first threshold value, it is determined that the ground line is in a normal state and the correction of the behavior (Vout) of the first electric circuit (112) is not executed, when the detection voltage (V2) through the monitoring conductive line is not less than the second threshold value and less than the first threshold value, the correction of the behavior (Vout) of the first electric circuit (112) is executed using the detection voltage (V2) through the monitoring conductive line, and when the detection voltage (V2) through the monitoring conductive line becomes not less than the first threshold value, it is determined that the monitoring conductive line is disconnected.

In one mode for carrying out the present invention, the first electric circuit (112) is a detection circuit which detects a specific kind of physical quantity, and corrects an output voltage (Vout) of the detection circuit (112) using the detection voltage (V2) through the monitoring conductive line.

In one mode for carrying out the present invention, the correction of a physical quantity to be detected is executed by correcting the output voltage (Vout) of the detection circuit (112) and an upper limit value (VDD) of the output voltage (Vout) using the detection voltage (V2) through the monitoring conductive line.

In one mode for carrying out the present invention, the detection circuit (112) is a pressure sensor which detects pressure in a negative pressure booster which assists a braking device of a vehicle, and the output voltage (Vout) is a pressure detection signal.

In one mode for carrying out the present invention, the abnormality detection device further includes a third resistance (R7) which is interposed on the monitoring conductive line (L3a, 103a), one end of the third resistance (R7) is connected to the first resistance (R5), and the other end of the third resistance (R7) is connected to the second resistance (R6).

In one mode for carrying out the present invention, the monitoring conductive line is further connected to a ground potential through a first capacitor (C1) which is connected parallel to the second resistance (R6).

BRIEF DESCRIPTION OF THE DRAWINGS

Fig. 1 is a circuit diagram of a detection system according to a first embodiment of the present invention;

Fig. 2 is a circuit diagram of the detection system according to the first embodiment when a ground line is brought into a high resistance state in the circuit diagram;

Fig. 3 is a circuit diagram when a monitoring line and the ground line are connected to each other outside a sensor chip in the circuit diagram of the detection system according to the first embodiment;

Fig. 4 is a circuit diagram of a detection system according to a second embodiment of the present invention;

Fig. 5 is a circuit diagram when a ground line is brought into a high resistance state in the detection system according to the second embodiment of the present invention;

Fig. 6 is a view showing a modification in which, in the detection system of the second embodiment of the present invention, a resistance for adjusting a voltage is arranged in a detection device;

Fig. 7A is an equivalent circuit diagram when the ground line is brought into a high resistance state in the circuit diagram of the detection system according to the first embodiment;

Fig. 7B is an equivalent circuit diagram when the ground line is brought into a high resistance state in the circuit diagram of the detection system according to the second embodiment;

Fig. 8 is a circuit diagram when one embodiment of the present invention is applied to a power source line and a detection signal line;

Fig. 9 is a circuit diagram of a detection system according to a third embodiment;

Fig. 10 is an input/output characteristic curve which expresses the behavior of a circuit which is subject to diagnosis with respect to respective values of a peripheral environment;

Fig. 11 is a view for explaining an allowable range for determining that the behaviors of circuit before and after the change of an input voltage are on the same input/output characteristic curve;

Fig. 12 is a flowchart for explaining abnormality detection processing of a detection circuit 112 according to the third embodiment;

Fig. 13 is a view showing a case where the input/output characteristic is formed of a straight line in Fig. 10;

Fig. 14 is a flowchart for explaining the abnormality detection processing of the detection circuit 112 according to the third embodiment when the input/output characteristic is formed of a straight line;

Fig. 15 is a view showing a constitutional example of a power source voltage control circuit;

Fig. 16 is a circuit diagram of a detection system according to a fourth embodiment of the present invention;

Fig. 17 is a block diagram showing the constitution of the detection circuit;

Fig. 18 is a view showing a range of an output signal value of the detection circuit;

Fig. 19 is a view showing an input/output characteristic curve which expresses the behaviors of a circuit which is subject to diagnosis with respect to respective values of a peripheral environment;

Fig. 20 is a view showing a change of an input/output characteristic curve when a conductive line is brought into a high resistance state;

Fig. 21 is a view showing a change of an input/output characteristic curve when an abnormality occurs in the detection circuit;

Fig. 22 is a flowchart for explaining the abnormality detection processing of a detection circuit according to a fourth embodiment;

Fig. 23 is a flowchart for explaining the abnormality detection processing of a detection circuit according to a fifth embodiment;

Fig. 24 is a circuit diagram of a detection system according to a sixth embodiment;

Fig. 25 is an explanatory view for explaining a potential of a monitoring point in the detection system according to the sixth embodiment; and

Fig. 26 is an explanatory view for explaining the correction of an output of a detection circuit according to the sixth embodiment.

MODE FOR CARRYING OUT THE INVENTION

(First embodiment)

Fig. 1 shows a circuit diagram of a detection system according to the first embodiment of the present invention. Here, the explanation is made by taking a detection system which is used for detecting a pressure of a negative pressure booster for assisting a braking device of a vehicle as an example. However, this embodiment is not limited to the detection system and is applicable to an arbitrary electric system provided that the system is configured to perform the supply of power source or the transmission/reception of signals among a plurality of circuits.

[Circuit constitution]

A detection system 1 shown in Fig. 1 includes a detection device 100 and a processing device 200, and the detection device 100 and the processing device 200 are electrically connected with each other through signal lines (conductive lines) L1 to L3, L3a. The detection device 100 is a pressure detection device, and is a detection device which is mounted on a negative pressure booster (not shown in the drawing) for assisting a braking device of a vehicle and detects a pressure (negative pressure) in the negative pressure booster. The processing device 200 is, for example, an electronic control device (ECU) mounted on the vehicle. The processing device 200 supplies a power source voltage (input signal) to the detection device 100, receives a pressure detection signal (output signal) from the detection device 100 and uses the pressure detection signal for various controls of the vehicle.

The signal line L1 is a detection signal line through which a pressure detection signal is outputted from the detection device 100 to the processing device 200, and is connected to a detection signal electrode P1 of the detection device 100 and a detection signal terminal T1 of the processing device 200. The signal line L2 is a power source line through which a power source voltage Vcc (for example, 5V) is supplied to the detection device 100 from the processing device 200, and is connected to a power source electrode P2 of the detection device 100 and a power source terminal T2 of the processing device 200. The signal line L3 is a ground line through which a ground potential (GND) is supplied to the detection device 100 from the processing device 200, and is connected to a ground electrode P3 of the detection device 100 and a ground terminal T3 of the processing device 200. The signal line L3a is a monitoring line for monitoring and detecting an abnormality in the ground line L3, and a potential V2' on a detection device 100 side of the ground line L3 is supplied to the processing device 200 through the signal line L3a.

The detection device 100 includes a housing 110 formed by resin molding, and a sensor chip 111 arranged in the inside of the housing 110. The sensor chip 111 includes a pressure detection circuit 112, and the pressure detection circuit 112 is provided with, for example, a pressure sensor constituted of a diaphragm and a resistance bridge, an amplifier circuit and the like. The sensor chip 111 and the signal lines L1 to L3 are connected with each other by wires 101 to 103, 103a which constitute a detection signal line 101, a power source line 102, a ground line 103, and a monitoring line 103a respectively, while the pressure detection circuit 112 is connected with the signal lines L1 to L3 by way of the wires 101 to 103, 103a. The pressure detection circuit 112 detects a pressure in the negative pressure booster, and outputs a pressure detection signal to the detection signal terminal T1 of the processing device 200 through the detection signal line 101, the detection signal electrode P1 and the detection signal line L1. The pressure detection signal is inputted to a detection signal terminal 211 of an ADC 210 through a detection signal line 201. A power source voltage Vcc is supplied to the pressure detection circuit 112 from a power source Vcc of the processing device 200 through a power source line 202, the power source terminal T2, the power source line L2, a power source electrode P2 and the power source line 102. A ground potential GND is supplied to the pressure detection circuit 112 from the ground line 203 of the processing device 200 through a ground terminal T3, the ground line L3, a ground electrode P3 and the ground line 103.

A recessed portion which receives connectors (not shown in the drawing) mounted on one ends of the signal lines L1 to L3, L3a is formed on the housing 110 at the time of forming the housing 110 by resin molding, and comb-teeth-shaped electrodes P1 to P3, P3a which correspond to the respective signal lines L1 to L3, L3a are provided in a state where the electrodes P1 to P3, P3a penetrate a bottom surface of the recessed portion from the inside to the outside of the housing. The recessed portion and the electrodes P1 to P3, P3a constitute a connector on a detection device 100 side. When the connector on a signal lines L1 to L3, L3a side is fitted in the recessed portion of the housing 110, the signal lines L1 to L3, L3a are electrically connected to the electrodes P1 to P3, L3a respectively. Inside the housing 110, the electrodes P1 to P3, P3a are respectively formed into a shape for receiving distal end portions of the wires 101 to 103, 103a, and distal ends of the wires 101 to 103, 103a are fitted into and are connected to the respective electrodes P1 to P3. Due to such a constitution, the wires 101 to 103, 103a are respectively made electrically conductive with the signal lines L1 to L3, L3a through the electrodes P1 to P3. Further, the ground lines L3, 103 and the monitoring lines L3a, 103a are made electrically conductive with each other in the inside of a sensor chip 111.

In the processing device 200, the analog/digital converter (ADC) 210 is provided. The ADC 210 includes the detection signal terminal 211 to which a pressure detection signal is inputted, a reference terminal 212 to which a power source voltage Vcc is supplied through the power source line 202 in the processing device 200, a signal terminal 213 to which a potential on a processing device 200 side of the ground lines L3, 103 (ground potential V1 of the processing device 200 (V1=GND)) is inputted, and a monitoring terminal 213a to which a potential V2 on a detection device 100 side of the ground lines L3, 103 is inputted through the monitoring lines 103a, L3a, 203a.

Further, the detection signal terminal T1 of the processing device 200 is connected to the detection signal terminal 211 of the ADC 210 through the detection signal line 201, and the detection signal terminal T1 is also connected to a power source VA through a pull-up resistance R2. For example, assume that the resistance R2 is set to 680kΩ (R2=680 kΩ) and the power source voltage Va is set to a fixed voltage of 5.5 to 16V (VA=5.5 to 16V). When the detection signal terminal T1 is brought into an open state due to the disconnection of the detection signal line L1 or the like, the voltage VA is inputted to the detection signal terminal 211 of the ADC 210 through the resistance R2 and the detection signal line 201. For example, when the signal lines L1 to L3 are in a normal state, a voltage of the pressure detection signal which is inputted to the ADC 210 is changed within a range from 0.25V to 4.75V, while when the detection signal line L1 is disconnected (when the detection signal terminal T1 is brought into an open state), a voltage which is inputted to the ADC 210 from the power source VA through the resistance R2 becomes not less than 5V. Based on the difference between the input voltages supplied to the ADC 210, the disconnection of the detection signal line L1 can be detected.

In such a detection system 1, a power source voltage Vcc is supplied to the pressure detection circuit 112 in the sensor chip 111 from the power source Vcc of the processing device 200 through the power source line 202 and the power source lines L2, 102. Further, a pressure detection signal from the pressure detection circuit 112 is supplied to the detection signal terminal 211 of the ADC 210 through the detection signal lines 101, L1, 201. Further, the ground potential GND of the processing device 200 is supplied to the pressure detection circuit 112 of the detection device 100 from the ground line 203 through the ground lines L3, 103. Further, a ground potential GND of the processing device 200 is inputted to the signal terminal 213 of the ADC 210 from the ground line 203, and a potential V2' at a connection point (monitoring point) between the ground line L3, 103 and the monitoring line L3a, 103a is inputted to the monitoring terminal 213a of the ADC 210 through the monitoring line 103a, the monitoring electrode P3a and the monitoring lines L3a, 203a.

[Abnormality detection processing]

Hereinafter, the abnormality detection processing of the ground line in the detection system 1 is explained. In this abnormality detection processing, a resistance state of the ground line is detected based on a potential V2' at the connection point between the ground line and the monitoring line on the pressure detection circuit 112 side. In the explanation made hereinafter, a potential (V1=GND) of the ground line 203 is used as a reference value, and the potential V1 is set to 0 (V1=0).

When the ground lines L3, 103 are in a normal state, the ground line 103 of the detection device 100 is connected to the ground line 203 (V1=0) of the processing device 200 through the ground line L3 in a low resistance state, and a potential V2' at the connection point agrees with a ground potential V1(=0) of the processing device 200 (V2'=0).

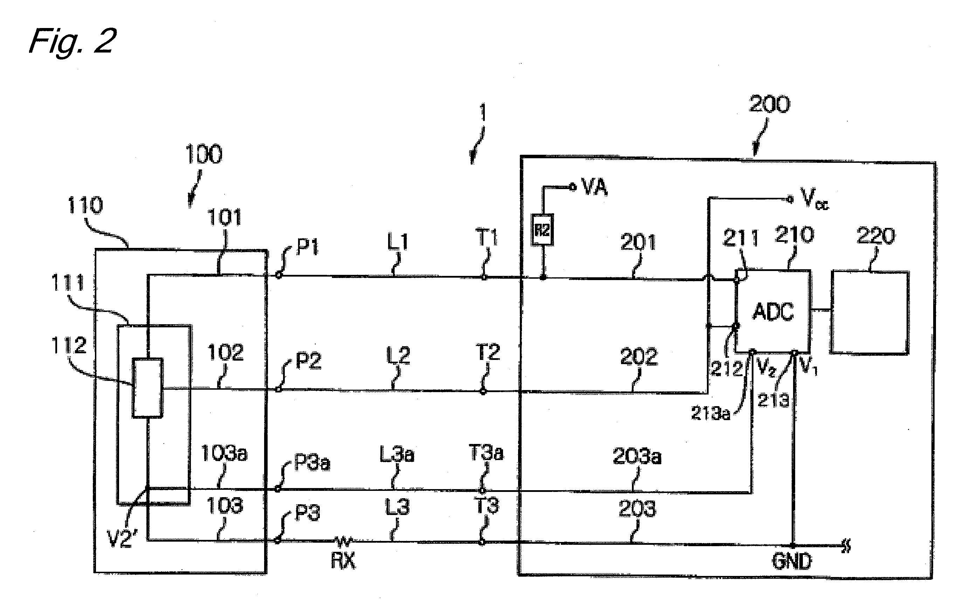

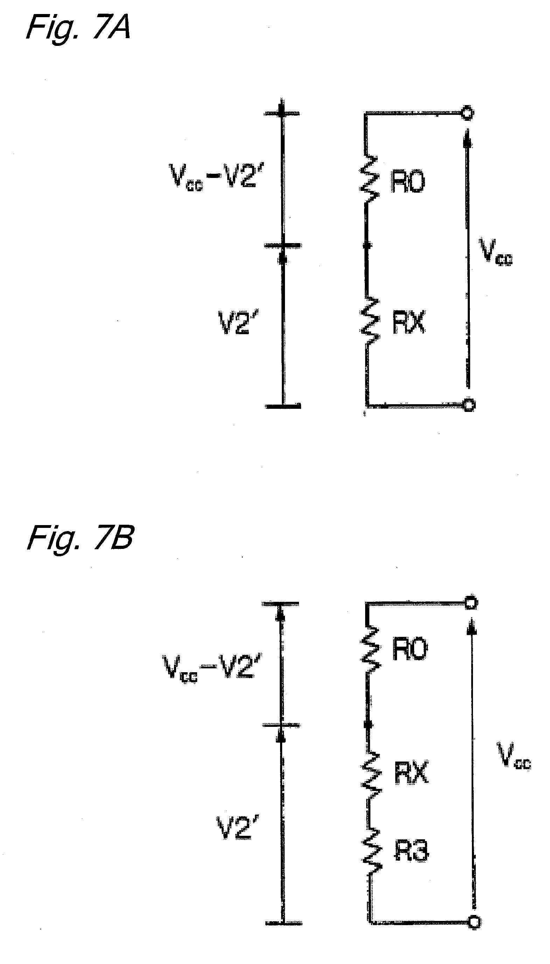

On the other hand, as shown in Fig. 2, there may be a case where contact at a connection portion between the ground electrode P3 and the ground line L3 or contact at a connection portion between the ground electrode P3 and the ground line 103 of the detection device 100 becomes defective due to vibrations caused by an operation of the negative pressure booster so that contact resistance is increased whereby resistance RX is generated on the ground lines L3, 103. In such a case, a potential V2' at the connection point is connected to the ground line 203 (V1=0) of the processing device 200 through the resistance RX. Here, as shown in an equivalent circuit in Fig. 7A, a power source voltage Vcc is divided by a resistance value R0 of the sensor chip 111 (a resistance value from an input part of the sensor chip 111 for the power source line 102 to the connection point (V2')) and the resistance RX. Accordingly, the resistance RX can be calculated by the following formula (1) using the potential V2' at the connection point.

$$RX=V2'/(Vcc-V2')*R0 \quad \ldots\ldots\ldots(1)$$

A resistance state of the ground line L3 can be evaluated using the resistance value RX. Further, the potential V2' at the connection point corresponds to the resistance value RX on a one-to-one basis and hence, a resistance state of the ground line L3 can be also evaluated using the potential V2' at the connection point.

Assuming that the power source voltage Vcc is 5V (Vcc=5V) and the resistance value R0 is 500Ω (R0=500Ω), the resistance RX(=10Ω) is connected between the ground electrode P3 and the ground line L3 (or between the ground electrode P3 and the ground line 103), and a potential V2'(=V2) at the connection point is measured. The result shows that V2'=V2=0.098V. Substituting this value into the formula (1), the resistance RX becomes 9.996Ω (RX=9.996Ω). When a resistance RX(=300Ω) is connected between the ground electrode P3 and the ground line L3 (or between the ground electrode P3 and the ground line 103), the potential V2'(=V2) at the connection point becomes 1.894V. Substituting this value into the formula (1), the resistance RX becomes 304.9Ω (RX=304.9Ω). As a result, it is understood that a resistance state of the ground line can be accurately evaluated by measuring the potential V2' at the connection point.

When the resistance value RX caused by a contact failure or the like is increased, a potential V2'(=V2) at the connection point is also increased and hence, the determination of a resistance state of the ground line is preferably performed as follows using the potential V2' at the connection point or an input V2 supplied to the ADC 210. By determining that "the ground line is in a normal state" when the relationship of V2'=V2=0 (-10mV<V2'=V2<10mV in this embodiment) is established, and by determining that "the ground line is in a high resistance state" when the relationship of 10mV≤V2'=V2 is established, abnormality that the ground lines L3, 103 is brought into a high resistance state can be detected. Although it is determined that V2'(=V2) agrees with a predetermined value (0V) when V2'(=V2) falls within a range of -10mV<V2'=V2<10mV in this embodiment, this range is suitably decided corresponding to the resolution of the ADC 210.

Specific processing executed by the processing device 200 is as follows. A potential V1(=0) (reference value) on a processing device 200 side of the ground line L3 is inputted to the signal terminal 213 of the ADC 210, and a potential V2' (=V2) at the connection point is inputted to the monitoring terminal 213a of the ADC 210 through the monitoring line 103a, the monitoring electrode 3a and the monitoring lines L3a, 203a. The ADC 210 converts the potential V1 (reference value) on a processing device 200 side of the ground lines L3, 103 and the potential V2 at the connection point into digital signals respectively and the ADC outputs the respective digital signals to a processing part 220. The processing part 220 calculates a potential difference ΔV (=V2-V1). When the potential difference ΔV falls within a range of -10mV<AV<10mV, the processing part 220 determines that "the ground line is in a normal state". On the other hand, when the potential difference ΔV satisfies the relationship of 10mV≤AV, the processing part 220 determines that "the ground line is in a high resistance state" and performs an alarm display indicating that "the ground line is in a high resistance state".

In the processing part 220, the resistance value RX of the ground line may be calculated using a detected value of V2' and the formula (1). In this case, a change in resistance value of the ground line and abnormality that the ground line is brought into a high resistance state can be detected by monitoring the resistance value RX.

According to the above-mentioned first embodiment of the present invention, by monitoring a potential V2' at the connection point between the ground line L3, 103 and the monitoring line L3a, 103a through the monitoring line L3a, 103a, a resistance state of the ground line can be detected. Accordingly, abnormality that the ground line L3, 103 is brought into a high resistance state can be surely detected. To consider a case where the detection device 100 is mounted on a negative pressure booster, when vibrations caused by an operation of the negative pressure booster are transmitted to the detection device 100 so that contact between the ground line L3, 103 and the electrode P3 becomes poor whereby a contact resistance is increased, abnormality that the ground line L3, 103 is brought into a high resistance state can be surely detected. According to the above-mentioned first embodiment of the present invention, a resistance value RX of the ground line can be also detected.

Further, according to the above-mentioned embodiment, by monitoring a potential V2' at the connection point between the ground lines L3, 103 and the monitoring lines L3a, 103a through the monitoring lines L3a, 103a, a resistance state of the ground lines L3, 103 can be directly detected and hence, abnormality can be surely detected with the simple constitution.

[Modification]

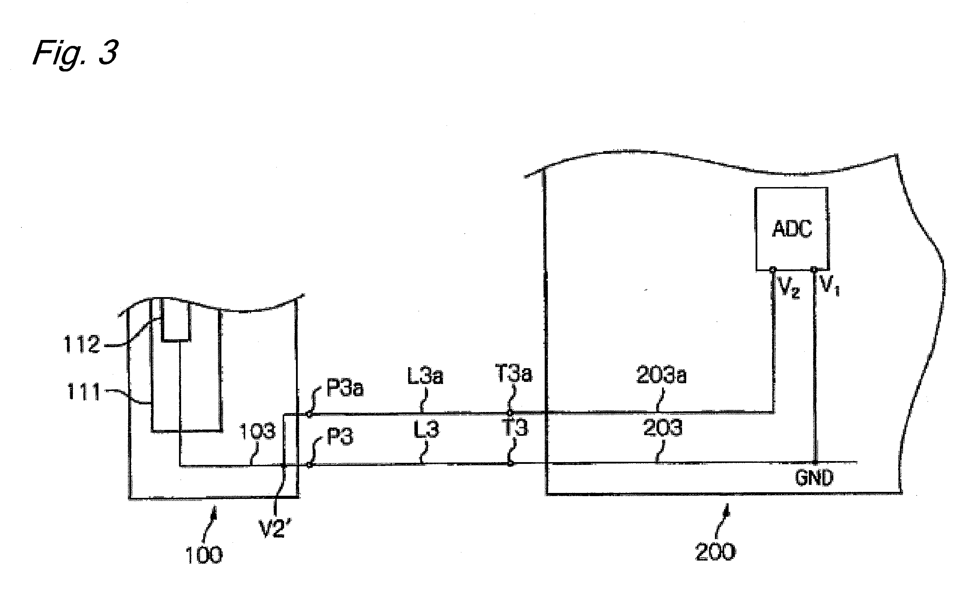

Although the detection system has been explained heretofore by taking the case where the ground lines L3, 103 and the monitoring lines L3a, 103a are made electrically conductive with each other in the inside of the sensor chip 111 as an example, as shown in Fig. 3, the monitoring line L3a and the ground line L3 may be made electrically conductive with each other by making the monitoring electrode P3a and the ground electrode 103 electrically conductive with each other.

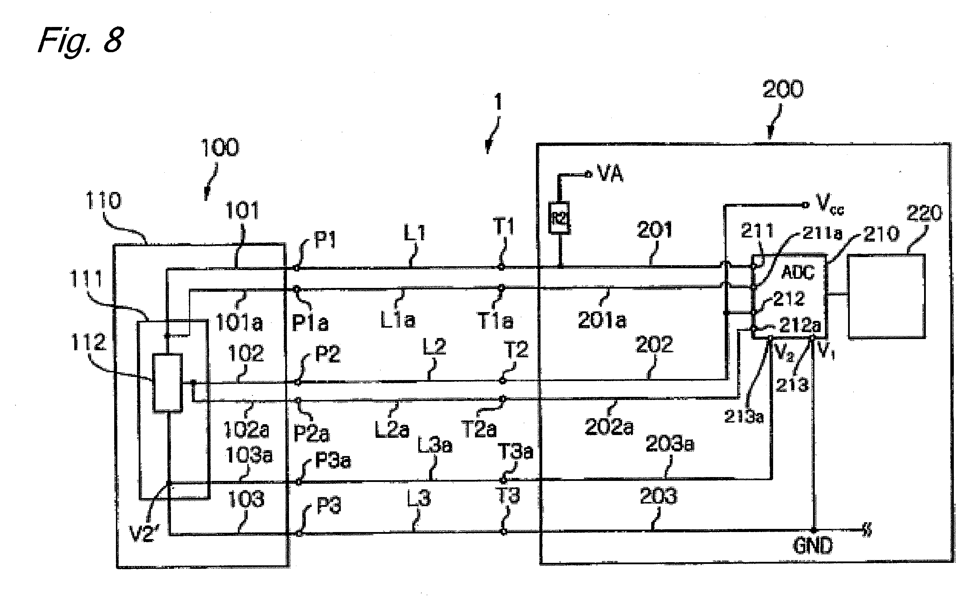

In the explanation made heretofore, a resistance state of the ground lines L3, 103 is detected by providing the monitoring lines L3a, 103a which are made electrically conductive with the ground lines L3, 103 on a detection device 100 side. However, as shown in Fig. 8, this embodiment is also applicable to the power source lines L2, 102 and the detection signal lines L1, 101. When this embodiment is applied to the power source line, a resistance state of the power source line is detected by using a power source potential Vcc inputted to the terminal 212 of the ADC 210 as a reference value and by monitoring a potential at a connection point between the power source lines L2, 102 and the monitoring lines L2a, 102a. When this embodiment is applied to the detection signal line, for example, a resistance state of the detection signal line is detected by using a detection signal voltage at the time of calibration which releases a pressure in the negative pressure booster to the atmosphere (a voltage inputted to the terminal 211 of the ADC 210) as a reference value, by detecting a potential at a connection point between the detection signal lines L1, 101 and the monitoring lines L1a, 101a and by comparing the potential and the reference value with each other.

Here, although the detection system has been explained in this embodiment with respect to the case where the ADC 210 and the processing part 220 are arranged in the inside of the processing device 200, the processing part 220 may be arranged outside the processing device 200, or both the ADC 210 and the processing part may be arranged outside the processing device 200.

Further, in the detection device 100, a device which is constituted by arranging the sensor detection circuit 112 on a printed circuit board may be used in place of the sensor chip 111.

(Second embodiment)

Fig. 4 shows a circuit diagram of a detection system according to the second embodiment of the present invention. In this embodiment, while constitutions identical with the constitutions of the first embodiment are given the same symbols, and the repeated explanation of these constitutions is omitted. Parts which make this embodiment different from the first embodiment are explained hereinafter.

In the first embodiment, when the monitoring line L3a per se is disconnected, the monitoring terminal 213a of the ADC 210 is brought into an open state and hence, V2 becomes a ground potential V1 (V1=0) whereby the relationship of V2=$\Delta$V=0 is established. On the other hand, as described above, when the ground line is in a normal state, the relationship of V2=$\Delta$V=0 is established and hence, this normal case cannot be distinguished from the abnormal case where the monitoring line L3a per se is disconnected (V2=4V=0). That is, in the first embodiment, abnormality that the monitoring line L3a per se is disconnected cannot be detected. In view of the above, the second embodiment provides a detection system which can detect the abnormality that the monitoring line L3a per se is disconnected.

As shown in Fig. 4, in the second embodiment, a resistance R3 (10$\Omega$) for correcting a potential is interposed on the ground line 203 in the detection device 100.

Hereinafter, the abnormality detection processing of the ground line in the detection system 1 according to the second embodiment is explained. When the ground lines L3, 103 are in a normal state, a potential V2'(=V2) at a connection point between the ground lines L3, 103 and the monitoring lines L3a, 103a, due to the connection with the ground line 203 through the resistance R3, becomes higher compared to a case where V1 is 0 (V1=0) by an amount of voltage step-down generated by a resistance R3 (99mV at R3(=10$\Omega$)). Accordingly, in the second embodiment, V2'(=V2=99mV ($\Delta$V=V2-V1=0.1V)) becomes the reference for determining that "The ground line is in a normal state". This corresponds to the correction of the reference value V2'(=V2=0 ($\Delta$V=0)) for determining that "The ground line is in a normal state" in the first embodiment by +99mV using the resistance R3.

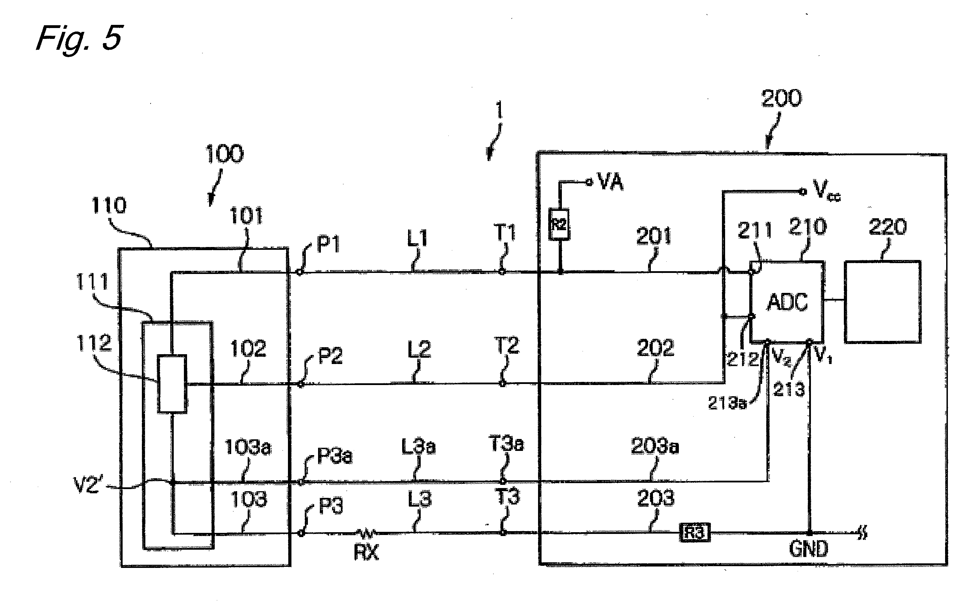

On the other hand, as shown in Fig. 5, when a contact resistance at a connecting portion between the electrode P3 and the ground line L3 of the detection device 100 (or a connecting portion between the electrode P3 and the ground line 103) is increased so that a resistance RX is generated on the ground lines L3, 103, a power source voltage Vcc is, as shown in an equivalent circuit in Fig. 7B, divided by a resistance value R0 of the sensor chip 111, the resistance R3, and the resistance RX. Accordingly, the resistance RX can be calculated by a following formula (2) using the potential V2' at the connection point.

$$RX=V2'/(Vcc-V2')*R0-R3 \quad \text{........................} (2)$$

As a result of measurement of a potential V2'(=V2) at the connection point in a state where R0 is set to 500$\Omega$ (R0=500$\Omega$), R3 is set to 10$\Omega$ (R3=10$\Omega$), Vcc is set to 5V (Vcc=5V) and there is no resistance RX (RX=0), the relationship of V2'=V2=99mV is established. Substituting this value into the formula (2), RX becomes 0.100$\Omega$ (RX=0.100$\Omega$) so that RX substantially agrees with 0$\Omega$. Further, when the resistance RX.(=300$\Omega$) is connected between the ground electrode P3 and the ground line L3 (or between the ground electrode P3 and the ground line 103), a measured value of a potential at the connection point satisfies the relationship of V2'=V2=1.927V, and the RX becomes 303.5$\Omega$ (RX=303.5$\Omega$). Accordingly, it is found that the value of the resistance RX can be obtained based on the potential V2' at the connection point.

On the other hand, when the monitoring line L3a, 103a is disconnected, V2 becomes 0 (V2=0) so that the relationship of V1=V2=0, that is, the relationship of $\Delta$V=V2-V1=0 is always established. As described above, in this embodiment, when "the ground line is in a normal state", the relationship of V2=$\Delta$V=99mV is established. Accordingly, it is possible to distinguish the case where the monitoring line is disconnected ($\Delta$V=0) from the case where "the ground line is in a normal state" ($\Delta$V=99mV). Accordingly, when $\Delta$V is 0, it is determined that "the monitoring line is disconnected".

The determination of a resistance state of the ground line is performed as follows using a potential V2' at the connection point or an input V2 of the ADC 210. When the relationship of 99mV-10mV<V2($\Delta$V)<99mV+10mV is established, it is determined that "the ground line is in a normal state". When the relationship of 99mV+10mV$\leq$V2($\Delta$V)is established, it is determined that "the ground line is in a high resistance state". When the relationship of -10mV<V2($\Delta$V) <10mV is established, it is determined that "the monitoring line is disconnected". In this embodiment, when V2($\Delta$V) falls within a range of a predetermined value (0V, 99mV) $\pm$10mV, it is determined that V2($\Delta$V) agrees with the predetermined value (0V, 99mV). However, this range is suitably decided corresponding to the resolution of the ADC 210.

The specific processing executed by the processing device 200 is as follows. The ADC 210 outputs a digital signal corresponding to inputted analog signals V1, V2. The processing part 220 calculates $\Delta$V(=V2-V1) based on the digital signals V1, V2. The processing part 220 determines that "the ground line is in a normal state" when the potential difference $\Delta$V falls within the range of 99mV-10mV<AV<99mV+10mV, determines that "the ground line is in a high resistance state" when the potential difference $\Delta$V falls within the range of 99mV+10mV<AV, and determines that "the monitoring line is disconnected" when the potential difference ΔV falls within the range of -10mV≤ΔV<10mV.

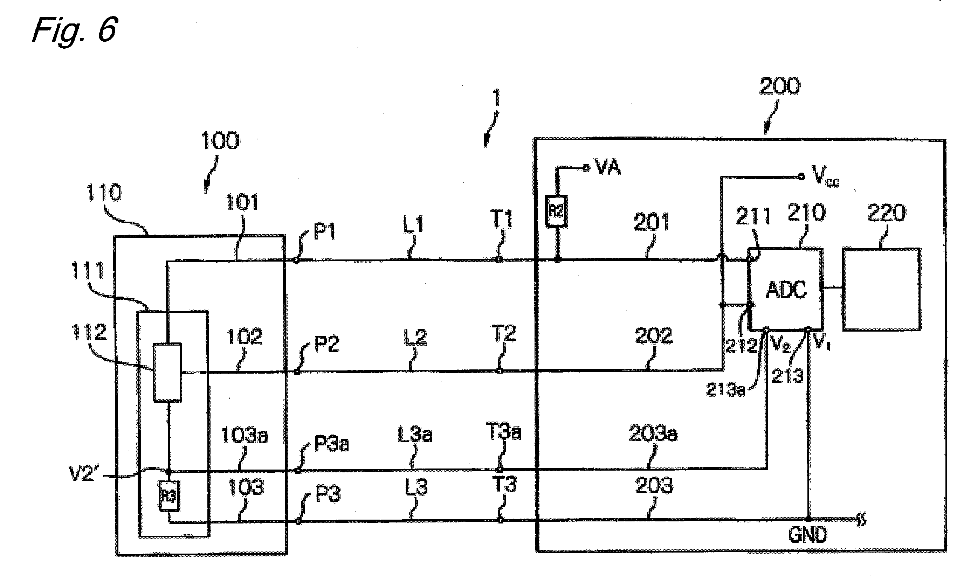

Although the resistance R3 is interposed on the ground line 203 in the inside of the processing device 200 in this embodiment, as shown in Fig. 6, the resistance R3 may be interposed on a ground line 103 side in the inside of the sensor chip 111. Further, the resistance R3 for potential correction may be arranged at any position on the ground line provided that the resistance R3 is electrically connected to the ground lines 103, 203 in series.

According to the second embodiment of the present invention described above, the second embodiment can obtain the substantially same manner of operation and advantageous effects as the first embodiment. Further, in the second embodiment, by interposing the resistance R3 for voltage correction on the path formed of the ground lines 203, L3 and 103 in series, an input voltage V2 of the ADC 210 at which it is determined that "the ground line is in a normal state" is corrected by an amount of voltage step-down generated by the resistance R3 (99mV) and hence, the case where the "the ground line is in a normal state" and the case where the monitoring line L3a, 103a per se is disconnected (ΔV=0) can be distinguished from each other. Accordingly, abnormality that "the monitoring line is disconnected" can be detected.

(Third embodiment)

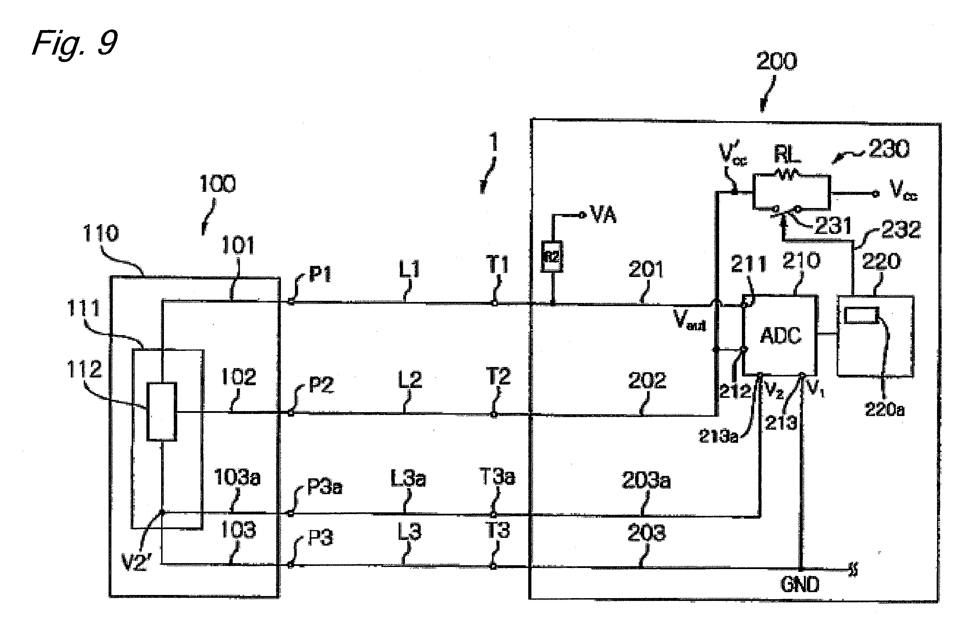

Fig. 9 shows a circuit diagram of a detection system according to the third embodiment of the present invention. This embodiment has the substantially same constitution as the detection system according to the first embodiment shown in Fig. 1 except for a point that a power source voltage control circuit 230 is added to the power source line. Hereinafter, parts having the substantially same constitution as the corresponding parts of the first embodiment are given the same symbols, while the constitution which makes the third embodiment different from the constitution of the first embodiment is explained in detail.

[Circuit constitution]

The detection system 1 shown in Fig. 9 is configured such that, in the detection system 1 shown in Fig. 9, the power source voltage control circuit 230 is interposed on the power source line 202 of the processing device 200, and an abnormality detection part 220a which detects abnormality in the detection circuit 112 based on a pressure detection signal (output signal) Vout after a power source voltage is changed is provided to the processing part 220. Although the explanation is made with respect to a case where the power source voltage control circuit 230 is arranged in the inside of the processing device 200 in this embodiment, the power source voltage control circuit 230 may be arranged outside the processing device 200.

The power source voltage control circuit 230 is interposed on the power source line 202 in series and includes a resistance RL for voltage step-down and a switching circuit 231. In the explanation made hereinafter, a supply path of a power source voltage Vcc' which does not go through the resistance RL is referred to as a path I, and a supply path of the power source voltage Vcc' which passes the resistance RL is referred to as a path II. The resistance RL steps down a power source voltage Vcc by an amount of a predetermined voltage ΔVcc, and outputs a power source voltage Vcc' (=Vcc-Δvcc) to the detection circuit 112. The switching circuit 231 outputs, in a conductive state, a power source voltage Vcc' (=Vcc) to the detection circuit 112 through the path I which does not go through the resistance RL, and outputs, in an open state, the power source voltage Vcc' (=Vcc-ΔVcc) to the detection circuit 112 through the path II which passes the resistance RL. The switching circuit 231 is constituted of, for example, a switch which has a mechanical contact or a semiconductor switch. The switching circuit 231 may have any constitution provided that the switching circuit 231 is an element or a circuit which can change over a supply path of the power source voltage Vcc between the path I and the path II. The switching circuit 231 is connected to an abnormality detection part 220a of the processing part 220 through a control line 232, and is changed over between a conductive state and an open state in response to a control signal from the abnormality detection part 220a.

For example, assuming that a power source voltage Vcc is 5V, RL is 125Ω, a resistance value of the detection circuit 112 (a resistance value between a connecting portion with the power source line 102 and a connecting portion with a ground line 103) is 5005, when the switching circuit 231 is in a conducive state, Vcc' (=Vcc=5V) is supplied to the detection circuit 112. On the other hand, when the switching circuit 231 is in an open state, 5V is divided by 125Ω(RL) and 500Ω (detection circuit 112) so that the power source voltage Vcc' (= 4V) is supplied to the detection circuit 112.

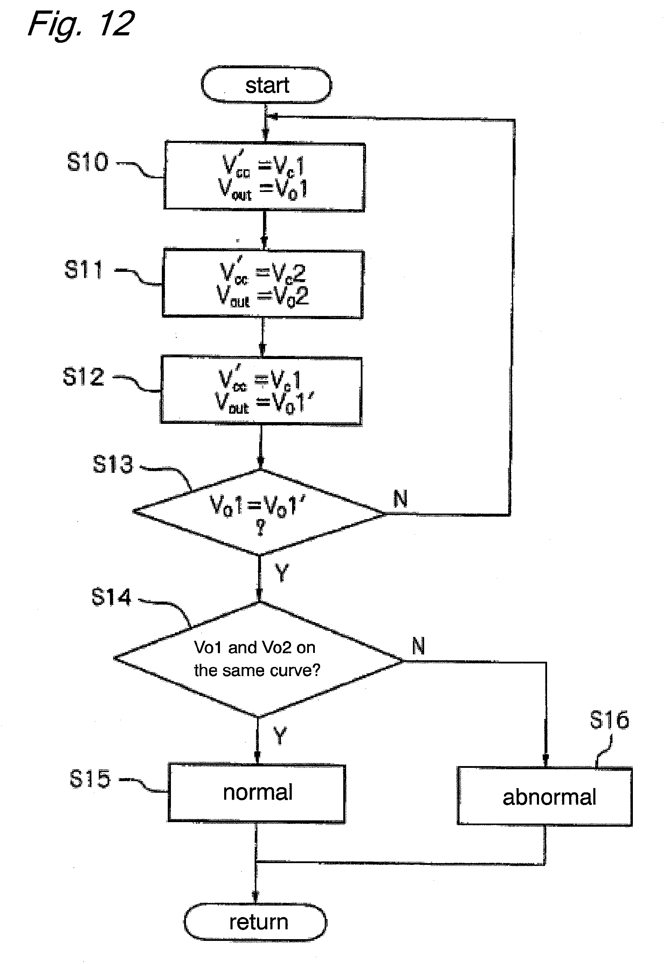

The processing part 220 is constituted of, for example, a CPU or a microprocessor, and executes abnormality detection processing in which a high resistance state of the signal lines (L1, 101; L2, 102; L3, 103) explained in conjunction with the first embodiment is detected. The processing part 220 further includes the abnormality detection part 220a which detects abnormality in the detection circuit 112 based on a detection signal (output signal) Vout after a change of the power source voltage. The abnormality detection part 220a changes a power source voltage Vcc' which is outputted to the detection circuit 112 by controlling the switching circuit 231 and executes abnormality detection processing (described later in conjunction with a flowchart shown in Fig. 12).

[Principle of detection of abnormality]

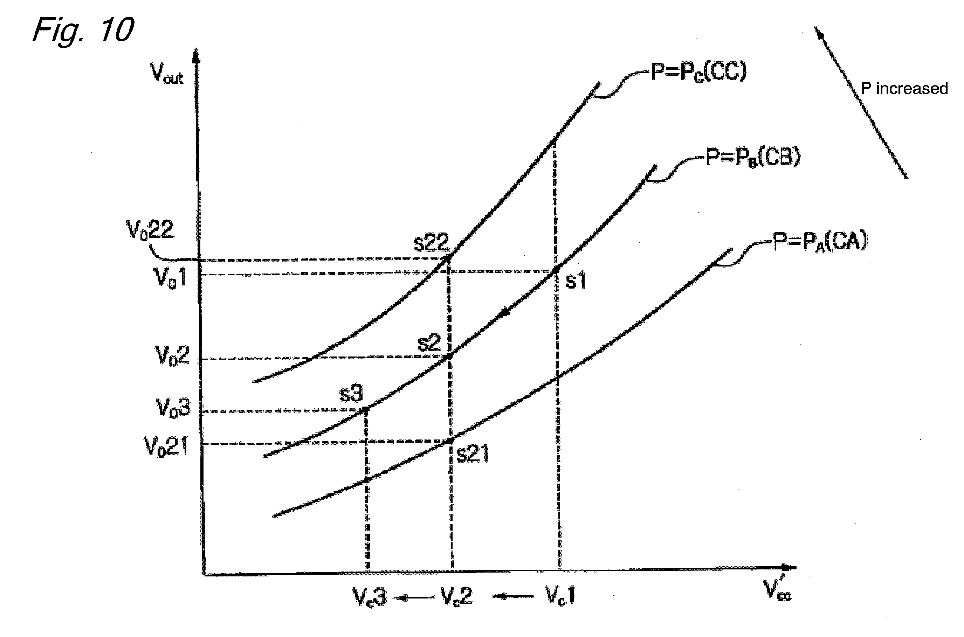

The abnormality detection processing according to this embodiment is explained in conjunction with Fig. 9 and Fig. 10.

Fig. 10 shows an input/output characteristic curve which expresses the behavior of a circuit which is subject to diagnosis with respect to respective values P of peripheral environment. In this embodiment, assume that the circuit which is subject to diagnosis is the detection circuit 112 of the detection device 100, and a value of the peripheral environment is a pressure value (a value of a negative pressure of a negative pressure booster) which is an object to be detected by the detection circuit 112. Further, assume that the behavior of the circuit which is subject to diagnosis indicates the relationship (Vcc', Vout) between an input (power source voltage Vcc') and an output (detection signal Vout) of the detection circuit 112 with respect to respective pressure values P. Further, assume that an input/output characteristic curve indicates the behavior (Vcc', Vout) of the detection circuit 112 with respect to a value (pressure value) P of the same peripheral environment by a curve (also including a straight line). Here, the present invention is not limited to the detection circuit and is applicable to an arbitrary electric circuit, an arbitrary electric element and an arbitrary electronic element whose behavior is changed corresponding to a value of the peripheral environment. Further, the value of the peripheral environment is not limited to the pressure value and may be an arbitrary physical quantity such as temperature, speed, acceleration, humidity. Further, the behavior of the circuit which is subject to diagnosis with respect to the respective values of the peripheral environment is not limited to input and output voltage values, and at least one of the input and the output may be an electric current.

Fig. 10 shows the input/output characteristic curves CA, CB, CC indicative of the behaviors (Vcc', Vout) of the detection circuit 112 when the pressure P is PA, PB, PC (PA < PB < PC). In Fig. 10, a point s1 indicates the behavior (Vc1, Vo1) of the detection circuit 112 when a power source voltage Vcc' (=Vcc =Vc1) (for example, 5V) is supplied in the detection system shown in Fig. 9 under the pressure P (= PB). A point s2 indicates the behavior (Vc2, Vo2) of the detection circuit 112 when a power source voltage Vcc' (= Vc2) (for example, 4V) is supplied under the pressure P (= PB). Points s21 and s22 indicate the behaviors (Vc2, Vo21) and (Vc2, Vo22) of the detection circuit 112 when a power source voltage Vcc' (=Vc2) (for example, 4V) is supplied under the pressure P (=PA and PC).

Here, assume a case where a power source voltage Vcc' is changed from Vc1 to Vc2 and an output signal Vout is detected within a time during which a pressure value in the negative pressure booster (value of the peripheral environment) is not changed, for example, within 100msec (preferably 10msec). In this case, when the detection circuit 112 is in a normal state, the value of the output signal Vout, that is, the behavior of the detection circuit 112 changes on the same input/output characteristic curve (CB) from the point s1 to the point s2 as shown in Fig. 10. On the other hand, when abnormality is present in the detection circuit 112, the value of the detection signal Vout, that is, the behavior of the detection circuit 112 changes and deviates from the same input/output characteristic curve (CB) such that the behavior deviates from the point s1 to the point s21 or the point s22 as shown in Fig. 10, for example.

Accordingly, the abnormality detection processing of the detection circuit 112 is executed in such a manner that in the case where the power source voltage Vcc' is changed from Vc1 to Vc2, it is determined that "the detection circuit 112 is in a normal state" when the behavior s of the detection circuit 112 (or the output signal Vout) moves on the same input/output characteristic curve before and after the change of the power source voltage, and it is determined that "the detection circuit 112 is in an abnormal state" when the behavior changes and deviates from the same input/output characteristic curve before and after the change of the power source voltage, and the abnormality detection processing is executed.

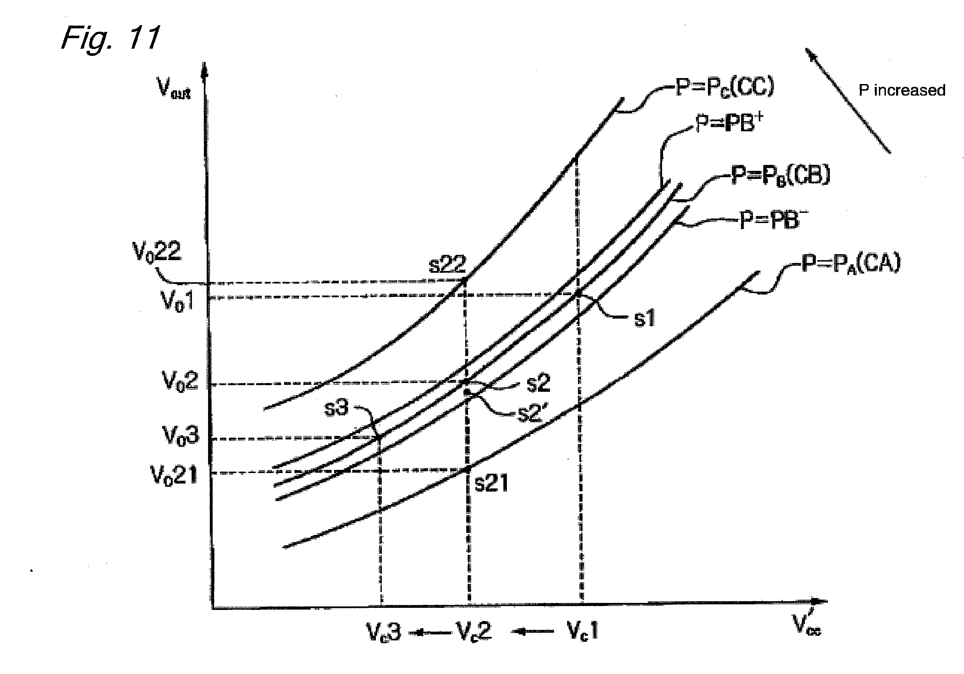

In an actual operation, to enable the detection of the pressure (value of the peripheral environment) before and after the change of the power source voltage (input) even when the pressure (value of the peripheral environment) is slightly fluctuated, a predetermined tolerance range may be provided as a criterion for determining that the behaviors s1, s2 before and after the change of the power source voltage are on the same input/output characteristic curve (or a criterion for determining that the detection circuit 112 is in a normal state). For example, as shown in Fig. 11, in the case where the P is PB before the input is changed, when a behavior s2' after the input is changed is present between input/output characteristic curves (a curve P=PB+, a curve P=PB-) with respect to to physical quantities P=PB ± predetermined errors (for example, 2%), it is determined that the behavior of the detection circuit 112 is on the same input/output characteristic curve (the detection circuit 112 is in a normal state) before and after the change of the power source voltage. That is, when an output signal Vo2' after the change of the power source voltage falls within a range of Vo2 ± predetermined error (for example, 1%), it is determined that the behavior of the detection circuit 112 is on the same input/output characteristic curve (the detection circuit 112 is in a normal state).

[Abnormality detection processing]

(Example 1 of abnormality detection processing)

Fig. 12 is a flowchart for explaining abnormality detection processing executed by the detection circuit 112 according to this embodiment.

In step S10, in a state where the power source Voltage Vcc' (=Vc1) (for example, 5V) is supplied to the detection circuit 112 (in a state where the power source voltage supply path I which does not go through the resistance RL is selected in the power source control circuit 230), the abnormality detection part 220a of the processing part 220 acquires a value of the power source voltage Vcc' (=Vc1) inputted to the reference terminal 212 of the ADC 210, and also acquires a value of a detection signal (output signal) Vout (=Vo1) (behavior s1 (Vc1, Vo1)) inputted to the detection signal terminal 211.

In step S11, the abnormality detection part 220a selects the power source voltage supply path II which passes the resistance RL by controlling the power source voltage control circuit 230, and allows the detection circuit 112 to output Vcc' (=Vc2) (<Vc1) (Vcc'=Vc1→Vc2). Then, the abnormality detection part 220a acquires a value of the power source voltage Vcc' (=Vc2) which is inputted to the reference terminal 212 of the ADC 210, and also acquires a value of the output signal Vout(=Vo2) (behavior s2 (Vc2, Vo2)) after the change of the power source voltage.

In step S12, the abnormality detection part 220a selects again the power source voltage supply path I which does not go through the resistance RL by controlling the power source voltage control circuit 230, and supplies the power source voltage Vcc' (=Vc1) to the detection circuit 112 (Vcc'=Vc2→Vc1). Then, the abnormality detection part 220a acquires a value of the power source voltage Vcc' (=Vc1) which is inputted to the reference terminal 212 of the ADC 210, and also acquires a value of the output signal Vout (=Vo1') (behavior s1 (Vc1, Vol')) inputted to the detection signal terminal 211.

In step S13, the value of the output signal Vout(=Vo1) which is acquired in step S10 and the value of the output signal Vout(=Vo1') which is acquired in step S12 are compared to each other. When both values agree with each other, that is, when a pressure value (a value of a peripheral environment) is not changed between step S10 and step S12, the processing advances to step S14 and the presence or non-presence of abnormality in the detection circuit 112 is determined. On the other hand, when it is determined that Vo1 and Vo1' differ from each other in step S13, the processing returns to step S10, and the acquisition of the output signal Vout before and after the change of the power source voltage is executed again.

In step S14, it is determined whether or not the output signal Vo1 of the detection circuit 112 before the change of the power source voltage (behavior s1 (Vc1, Vo1)) and the output signal Vo2 of the detection circuit 112 after the change of the power source voltage (behavior s2 (Vc2, Vo2)) are on the input/output characteristic curve at the same pressure value. When both output signals are on the same input/output characteristic curve, it is determined that the detection circuit 112 is in a normal state (step S15), while when both output signals are not on the same input/output characteristic curve, it is determined that the detection circuit 112 is in an abnormal state (step s16).

The reason the output signal Vo1 (behavior s1 (Vc1, Vo1)) with respect to the power source voltage value Vc1 before the change of the power source voltage is measured twice in steps S10 and S12 in the above-mentioned abnormality detection processing is that the presence and the non-presence of abnormality are determined by comparing the behaviors of the detection circuit 112 before and after the change of the power source voltage under the condition where the pressure value (value of the peripheral environment) is not changed. Even when there exists the tolerance of a predetermined range (for example, approximately 1%) in the measured values of the detection signal Vout obtained by carrying out the measurement twice with respect to the power source voltage Vc1 before the change of the power source voltage, it may be determined that the measured values obtained by carrying out the measurement twice agree with each other.

Further, in step S14, for example, values of output signals Vout(=Vo1, Vo2) (reference values) with respect to the power source voltages Vcc' (=Vc1, Vc2) are stored in advance with respect to respective physical quantities P (for example, PA, PB, PC). Then, the physical quantity P (PA, PB, PC) is decided corresponding to Vout(=Vo1) (detected value) acquired in step S10, and it is determined whether or not Vout(=Vo2) (detected value) acquired in step S11 agrees with Vo2 (reference value) with respect to the decided physical quantity P. Here, even when there is a predetermined tolerance (for example, 1%) in Vo2 (detected value), it may be determined that Vout(=Vo2) (detected value) agrees with the Vo2 (reference value).

Here, in the above-mentioned processing, it is determined that "the detection circuit 112 is in a normal state" when the output signal Vo1 (behavior s1) of the detection circuit 112 with respect to the power source voltage Vc1 before the change of the power source voltage and the output signal Vo2 (behavior s2) of the detection circuit 112 with respect to the power source voltage Vc2 after the change of the power source voltage are on the same input/output characteristic curve. However, as shown in Fig. 10, it may be determined that "the detection circuit 112 is in a normal state" when the power source voltage is changed from Vc1 to two or more different power source voltages (for example, Vc2, Vc3) and an output signal Vo2 (behavior s2) with respect to the power source voltage Vc2 after the change of the power source voltage and an output signal Vo3 (behavior s3) with respect to the power source voltage Vc3 after the change of the power source voltage are on the same input/output characteristic curve.

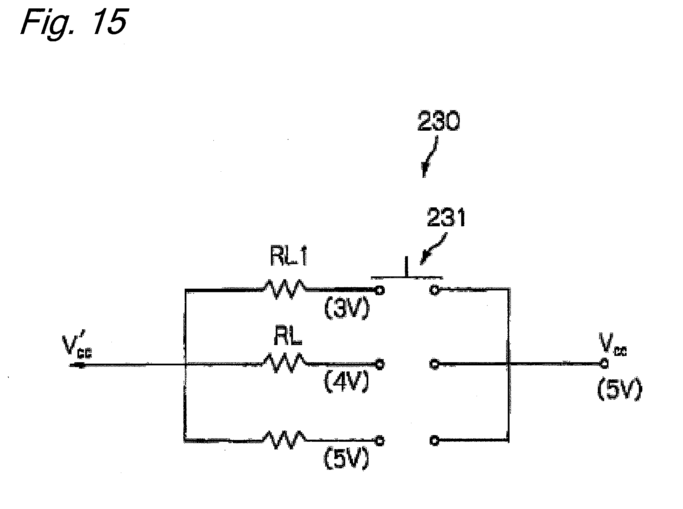

Further, as shown in Fig. 10, it may be determined that "the detection circuit 112 is in a normal state "when all of the output signal Vo1 (behavior s1) with respect to the power source voltage Vc1 before the change of the power source voltage, the output signal Vo2 (behavior s2) with respect to the power source voltage Vc2 after the change of the power source voltage, and the output signal Vo3 (behavior s3) with respect to the power source voltage Vc3 after the change of the power source voltage are on the same input/output characteristic curve. When the input/output characteristic with respect to a pressure value is formed of a curve, the presence or the non-presence of the abnormality in the detection circuit 112 can be determined with higher accuracy by determining whether or not three or more points are on the same input/output characteristic curve. In this case, for example, by constituting the power source voltage control circuit 231 as shown in Fig. 15 thus enabling the selection of a path through which a power source voltage is supplied via any one of the plurality of different resistances values RL, RL1, the power source voltage can be changed among a plurality of different values (for example, Vc2=4V, Vc3=3V).

(Example 2 of abnormality detection processing)

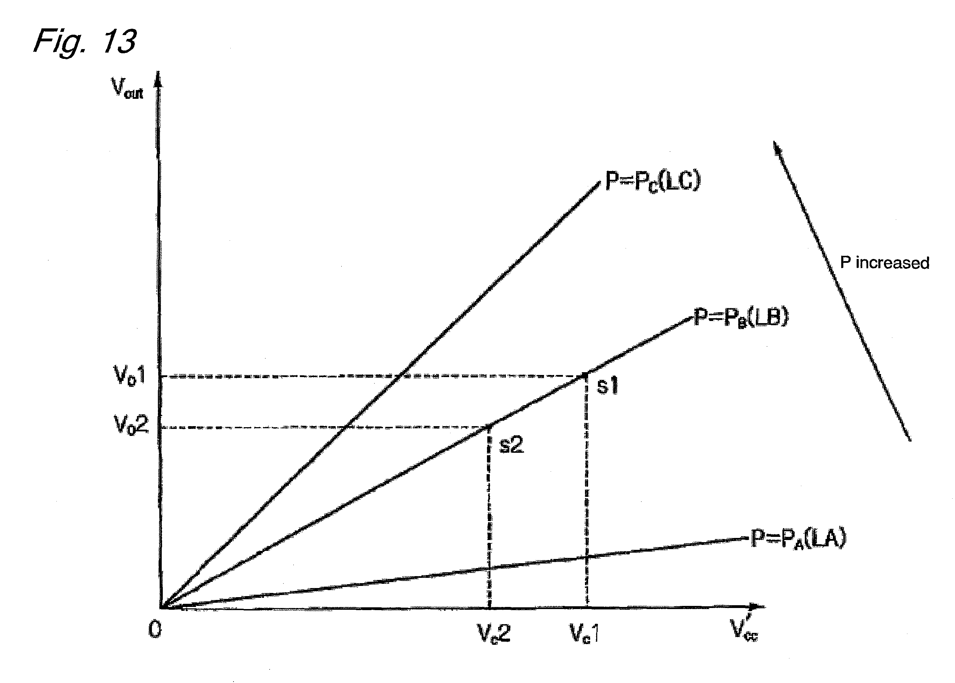

Fig. 13 shows, in the input/output characteristic curves shown in Fig. 10, input/output characteristic curves (input/output characteristic straight lines) when the relationship between an input (Vcc') and an output (Vout) of the detection circuit 112 is formed of a straight line with respect to the respective pressure values P.

When the relationship between the input and the output of the detection circuit 112 is formed of the straight line, it is determined whether or not an output signal Vo1 (behavior s1 (Vc1, Vo1)) of the detection circuit 112 before the change of the power source voltage and an output signal Vo2 (behavior s2 (Vc2, Vo2)) of the detection circuit 112 after the change of the power source voltage are on the same characteristic straight line by studying whether or not the output signals Vo1, Vo2 (behaviors s1, s2) of the detection circuit 112 before and after the change of the power source voltage are changed at a predetermined ratio.

For example, in Fig. 13, when a ratio Vo1/Vo2 of the outputs (Vout) before and after the change of the power source voltage agrees with a ratio Vc1/Vc2 of the inputs (Vcc') before and after the change of the power source voltage, it is possible to determine that the outputs (behaviors) before and after the change of the power source voltage are on the same straight line (LB). When the ratio Vo1/Vo2 and the ratio Vc1/Vc2 do not agree with each other, it is possible to determine that the outputs (behaviors) before and after the change of the power source voltage are not on the same straight line (LB). When Vc1 is 5V (Vc1=5V) and the Vc2 is 4V (Vc2=4V), by determining whether or not a ratio Vo1/Vo2 of the outputs before and after the change of the power source voltage agrees with a ratio 5/4 of the inputs (Vcc') before and after the change of the power source voltage, it is possible to determine whether or not the outputs (behaviors) before and after the change of the power source voltage are on the same characteristic straight line (LB) and whether or not the detection circuit 112 is in a normal state.

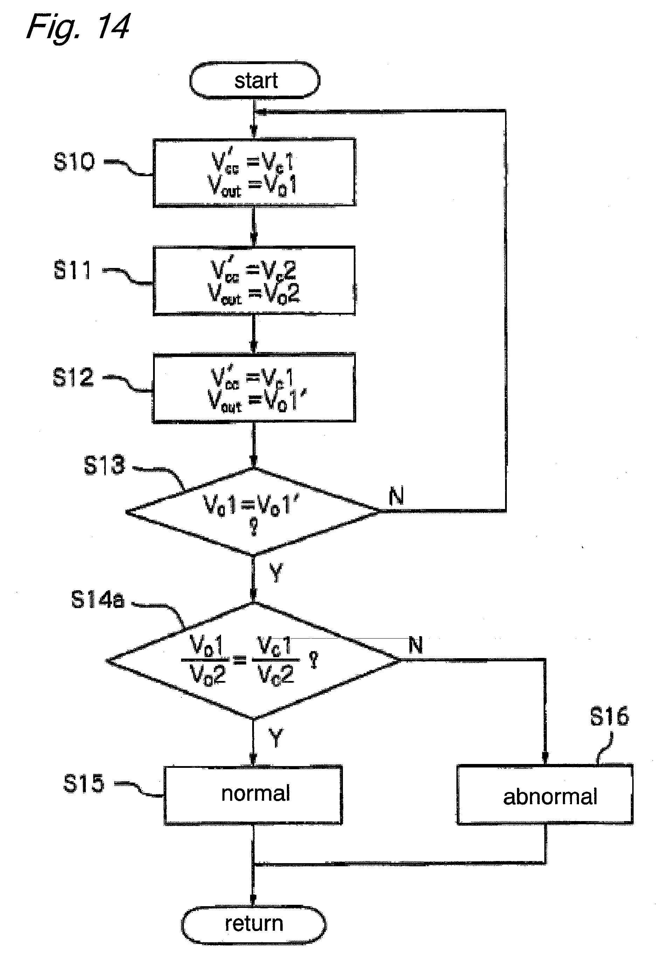

Fig. 14 is a flowchart for explaining the abnormality detection processing of the detection circuit 112 according to this embodiment when the input/output characteristic curve of the detection circuit 112 is formed of a straight line. In this flowchart, the steps other than step S14a are substantially equal to the steps in the flowchart shown in Fig. 12.

In step S14a, it is determined whether or not a ratio Vo1/Vo2 of output signals Vout before and after the change of the power source voltage agrees with a ratio Vc1/Vc2 of the power source voltages before and after the change of the power source voltage. When both ratios agree with each other, it is determined that the detection circuit 112 is in a normal state (step S15), while when both ratios do not agree with each other, it is determined that the detection circuit 112 is in an abnormal state (step S16).

For example, assume that the power source voltage Vcc' before the change of the power source voltage is 5V (Vcc'=5V) and the power source voltage Vcc' after the change of the power source voltage is 4V (Vcc'=4V). By setting the ratio Vc1/Vc2 of the power source voltages before and after the change of the power source voltage to 5/4 (Vc1/Vc2=5/4) (fixed value) in step S14a, it may be determined whether or not the ratio Vo1/Vo2 agrees with 5/4 (fixed value). Further, it may be determined whether or not the ratio Vo1/Vo2 agrees with the ratio Vc1/Vc2 (detected value) using Vc1 which is detected at the reference terminal 212 of the ADC 210 in step S10 and Vc2 which is detected at the reference terminal 212 of the ADC 210 in step S11.

Further, when the ratio Vo1/Vo2 of the outputs (Vout) before and after the change of the power source voltage falls within a range of Vc1/Vc2 $\pm$ predetermined tolerance (for example, 1%) in step S14a, it may be determined that "Vo1/Vo2 agrees with Vc1/Vc2".

Further, when the behavior of the detection circuit 112 is formed of a straight line as shown in Fig. 13, a formula expressing a straight line which passes a point s1 (Vc1, Vo1) obtained in step S10 and an origin (0, 0) is calculated, and a power source voltage Vcc' (=Vc2) after the change of the power source voltage is substituted into the formula of the straight line thus calculating an output Vout(=Vo2) (theoretical value) after the change of the power source voltage.

This processing is executed between step S13 and step S14a, for example. Then, in step S14a, abnormality in the detection circuit 112 may be detected by determining whether or not both the detected value Vo2 acquired in step S11 and the theoretical value Vo2 agree with each other by comparing the detected value Vo2 and the theoretical value Vo2 to each other. Here, also in this case, it may be determined that both the detected value Vo2 and the theoretical value Vo2 agree with each other when the detected value Vo2 falls within a range of predetermined tolerance (for example, 1%) of the theoretical value Vo2.

In Fig. 13 and Fig. 14, the explanation has been made by taking the case where the input/output characteristic curve is formed of the straight line which passes the origin as an example. However, in a case where the input/output characteristic curve does not go through the origin (when Vout is not 0 when Vcc' is 0 (Vcc'=0) and there exists an offset), an offset amount may be corrected based on the detected values of Vo1 and Vo2 obtained in steps S10 to S11, and the processing in step S14a may be executed.

According to the third embodiment described above, a resistance state of the signal line which is connected to the detection circuit 112 can be monitored using the monitoring line as described in detail in the first embodiment, and also abnormality in the detection circuit 112 per se can be surely detected with the simple constitution by evaluating the output signal Vout after the change of the power source voltage. That is, according to the third embodiment, the systematic abnormality detection with respect to the detection device 100 can be easily and surely executed with the simple constitution.

Further, in a method using a test pulse, it is necessary that a value of a peripheral environment (a pressure value or the like) of the detection circuit 112 is known at the time of performing abnormality detection processing. In a case of a pressure detection system of a negative pressure booster, there may be a case where a residual pressure remains in the negative pressure booster even at the time of stopping the engine. In this case, it is not possible to determine whether a pressure value at the time of stopping the engine is under an atmospheric pressure state or in a negative pressure residual state and hence, an abnormality diagnosis using a test pulse cannot be performed. To the contrary, according to the abnormality detection method of the detection circuit of this embodiment, it is unnecessary that a value of the peripheral environment (a pressure value or the like) per se is known. That is, provided that an input/output characteristic of the detection circuit 112 with respect to each pressure value is known in advance, abnormality in the detection circuit 112 can be detected by determining whether or not an output of the detection circuit 112 before and after the change of the power source voltage follows a known input/output characteristic (whether or not the output of the detection circuit 112 is on the same input/output characteristic curve).

[Modification]

Here, the monitoring lines described in the first and second embodiments and electrodes for connecting the monitoring lines may be omitted. For example, in Fig. 9, the monitoring lines 103a, L3a, 203a, the electrode P3a and the terminal T3a may be omitted. In this case, with respect to the detection device 100 and the processing device 200, it is possible to surely detect abnormality in the detection circuit 112 with the simple constitution without requiring additional signal lines for connecting both the detection device 100 and the processing device 200, and additional electrodes and terminals for connecting the additional signal lines. Parts to be added in the processing device 200 are only the power source voltage control circuit 231 which is constituted of the resistance RL, the switch 231 and the like. Accordingly, abnormality in the detection circuit 112 can be detected in accordance with software processing executed by the processing part 220a using the minimum number of parts to be added.

Further, when the processing device 200 is originally configured such that power source voltages of a regulator, DC/DC converter and the like are variable, it is unnecessary to add the power source voltage control circuit 231, and abnormality in the detection circuit 112 can be detected only in accordance with the software processing executed by the processing part 220a.

Further, although the explanation has been made with respect to the case where the power source voltage control circuit 230 is constituted of the resistance RL and the switch 231, the power source voltage control circuit 230 may be constituted of a regulator and a DC/DC converter.

Further, the abnormality detection processing of the detection circuit 112 according to this embodiment is applicable not only to the circuit shown in Fig.1 but also to the circuits shown in Fig. 3, Fig. 4, Fig. 6 and Fig. 8 and modifications of the respective circuits. That is, by combining the abnormality detection processing according to the third embodiment which uses the input/output characteristic of the detection circuit to the abnormality detection processing of the signal line according to the first and second embodiment which use the monitoring line, a resistance state of a signal line connected to the detection circuit 112 can be monitored, and abnormality in the detection circuit 112 per se can be also surely detected.

(Fourth embodiment)

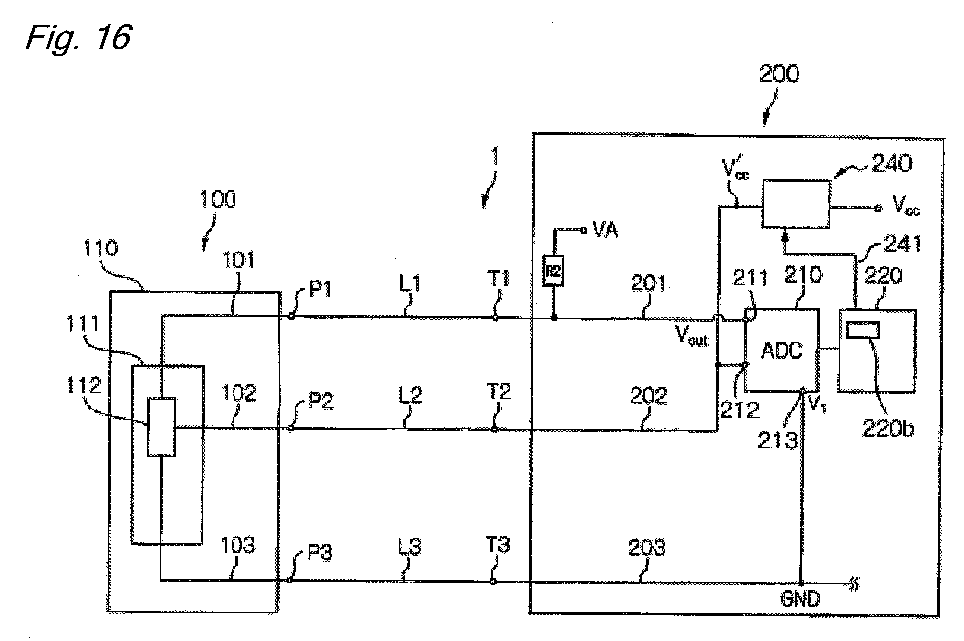

Fig. 16 shows a circuit diagram of a detection system according to a fourth embodiment of the present invention. This embodiment has the substantially same constitution as the detection system of the third embodiment shown in Fig. 9 except for a point that, in the detection system of the third embodiment shown in Fig. 9, a power source voltage control circuit 240 is provided in place of the power source voltage control circuit 230, an abnormality detection part 220b is provided in place of the abnormality detection part 220a, and the monitoring lines 103a, L3a and 203a are omitted.

[Circuit constitution]

The power source voltage control circuit 240 receives inputting of a power source voltage Vcc, continuously changes a power source voltage Vcc' and outputs the power source voltage Vcc' to a detection device 100. The power source voltage control circuit 240 is, for example, a circuit which continuously changes the power source voltage Vcc' by controlling a switching element such as a transistor, and is a regulator circuit such as a DC/DC converter, for example. The power source voltage control circuit 240 is connected to a processing part 220 through a control line 241, and a value of an output power source voltage Vcc' is controlled by the abnormality detection part 220b of the processing part 220.

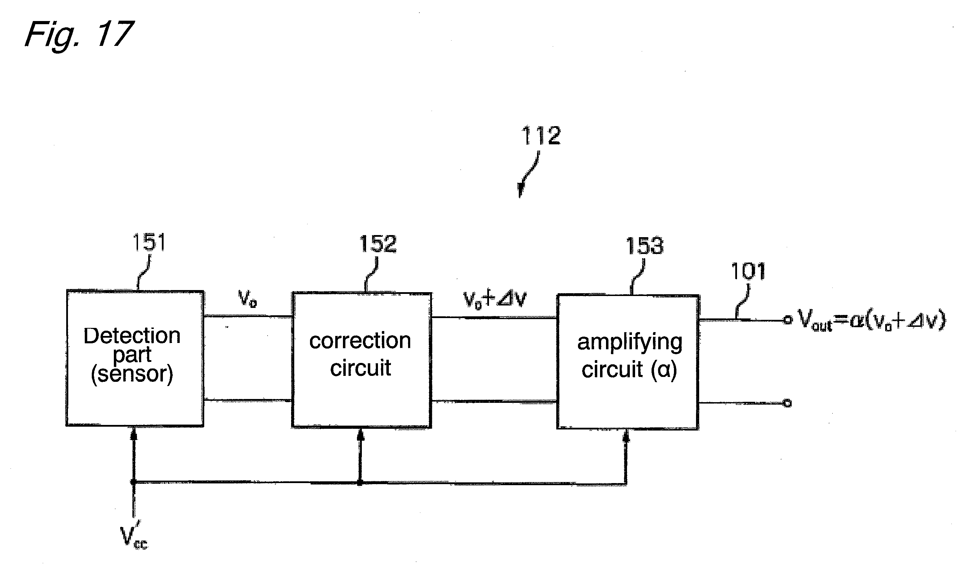

Fig. 17 is a block diagram showing the constitution of a detection circuit 112. The detection circuit 112 includes a detection part (sensor) 151 which detects a physical quantity such as a pressure, a correction circuit 152 which adds a predetermined correction $\Delta v$ to a detection signal vo outputted from the detection part 151, and an amplifier circuit 153 which amplifies a detection signal vo+$\Delta v$ obtained by correction performed by the correction circuit 152 at a predetermined amplification ratio $\alpha$ and outputs an output signal Vout (=$\alpha$(vo+$\Delta v$)). The output signal Vout is inputted to the processing device 200 through detection signal lines 101, L1.

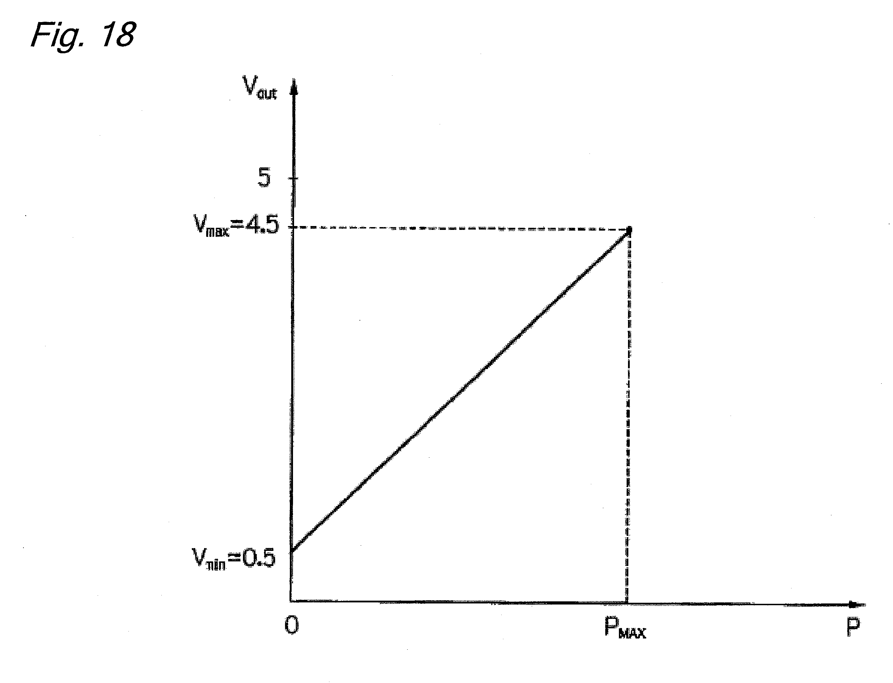

The detection part 151 is a pressure sensor constituted of a diaphragm and a resistance bridge, for example, and outputs an electric signal (detection signal) vo indicative of a change in resistance caused by the deformation of the diaphragm. The correction circuit 152, for example, adds a predetermined correction value $\Delta v$ to a detection signal vo obtained by the detection part 151 in such a manner that, as shown in Fig. 18, when the detection circuit 112 is used in a state where an output signal Vout falls within a range of 0.5V to 4.5V with respect to a detection pressure P (0 to Pmax) with the power source voltage Vcc' set to 5V (Vcc'=5V), the output signal Vout of the amplifier circuit 153 takes Vmin(= 0.5V) at P(=0) and the output signal Vout takes Vmax(=4.5V) at P (= Pmax (maximum detection pressure)). The correction value $\Delta v$ is adjusted corresponding to a value of a power source voltage Vcc' which is supplied to the detection circuit 112 and is proportional to the power source voltage Vcc'. For example, when the power source voltage Vcc' is 3V, the correction value $\Delta v$ is adjusted in the decreasing direction so as to allow an output signal Vout which falls within a range of 0.3V to 2.7V to be outputted from the amplifier circuit 153. Although the range of the output signal Vout with respect to the power source voltage Vcc'(=5V) is set to 0.5V to 4.5V as one example, there may be also a case where the above-mentioned operation is carried out with the output signal Vout set within a range of 0.25V to 4.75V or the like.

Principle of abnormality detection]

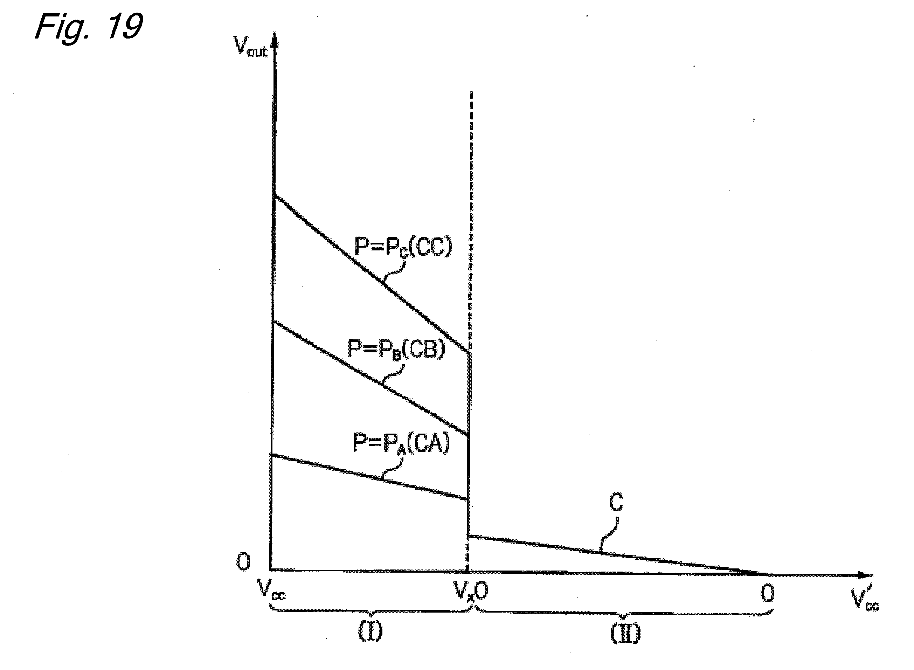

The abnormality detection processing according to this embodiment is explained in conjunction with Fig. 19 to Fig. 21.

Fig. 19 shows input/output characteristic curves of the detection circuit 112 with respect to respective pressure values (here, straight lines), and shows a change in the output signal Vout when the power source voltage Vcc' supplied to the detection circuit 112 is swept from Vcc (for example, 5V) to 0V with respect to a plurality of detection pressures P=PA, PB, PC (PA<PB<PC).

In Fig. 19, when the power source voltage Vcc' falls within a range from Vcc to Vx0 (an area I), the detection circuit 112 exhibits a characteristic that the output signal Vout is linearly decreased along with the decrease of the power source voltage Vcc' with respect to the respective pressure values P. This characteristic corresponds to a change of the output signal Vout when the power source voltage Vcc' is continuously decreased in the input/output characteristic shown in Fig. 13. Here, although the explanation is made by taking the case where the input/output characteristic of the detection circuit 112 is formed of a straight line as an example, the input/output characteristic may be formed of a curve in the same manner as the case of the third embodiment.

Further, this embodiment makes use of the characteristic that the detection part 151 of the detection circuit 112 shown in Fig. 17 is stopped when the relationship of Vcc'<Vx0 (minimum operation power source voltage) is established so that vo becomes 0 (vo =0) and the output signal Vout becomes $\alpha\Delta v$ (Vout =$\alpha\Delta v$) ($\Delta v$ being proportional to Vcc') whereby the characteristic is irrelevant to the pressure. To explain the embodiment in conjunction with Fig. 19, it is understood that the detection circuit 112 exhibits the characteristic that the output signal Vout changes on separate curves or straight lines for respective pressure values P in an area I (in the same manner as the change shown in Fig.

13), the output signal Vout changes on the same curve (or straight line) C irrelevant to the pressure values PA to PC in an area II (Vcc'<Vx0) using Vcc'(=Vx0) as a boundary. In this manner, the input/output characteristic of the detection circuit 112 according to this embodiment includes the area I where the output signal Vout changes corresponding to the power source voltages Vcc' for the respective pressure values P, and the area II where the output signal Vout changes corresponding to the power source voltage Vcc' irrelevant to the pressure value P.

In this embodiment, by making use of such an input/output characteristic constituted of the area I and the area II, abnormality in a conductive line which connects the detection circuit 112 and an external circuit to each other and abnormality in the detection circuit 112 per se (abnormality in the inside of the detection circuit 112) are detected.

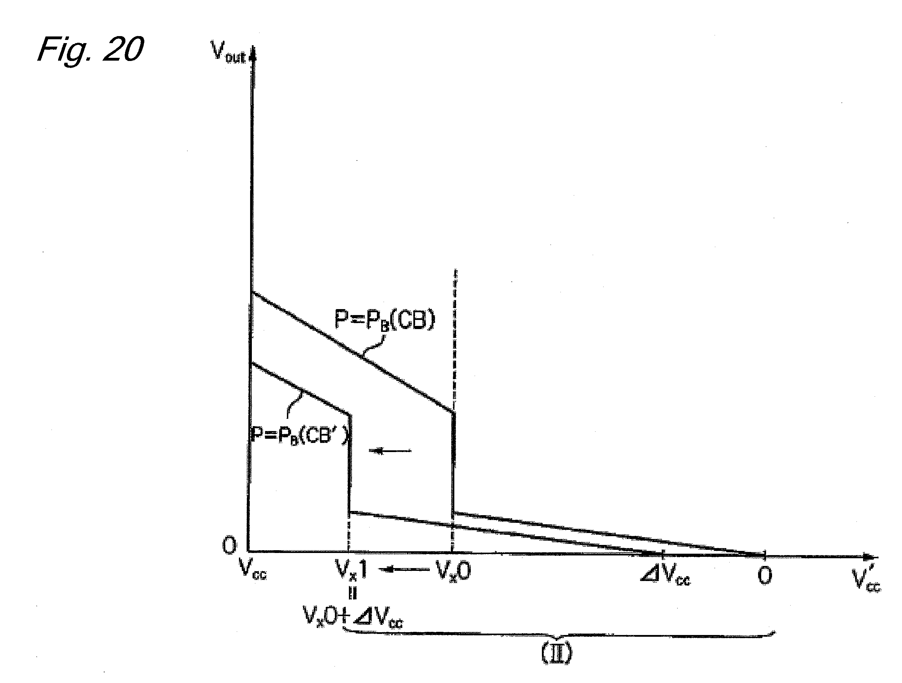

Firstly, as shown in Fig. 20, based on a change of the minimum operation power source voltage Vx (Vx0→Vx1), abnormality that any one of the conductive lines (L1, 101; L2, 102; L3, 103) is in a high resistance state is detected. In Fig. 16, any one of the conductive lines (L1, 101; L2, 102; L3, 103) is brought into a high resistance state because of a contact resistance or the like in the terminal P1 to P3 so that a resistance RX is generated on the conductive line L3 (see Fig. 2 or the like), for example, ΔVcc which is a part of Vcc' supplied from the power source voltage control circuit 240 is consumed by the resistance RX so that Vcc'-ΔVcc is supplied to the detection circuit 112. As a result, when a power source voltage Vcc'(=Vx0+ΔVcc) is outputted from the power source voltage control circuit 240, Vx0 is supplied to the detection circuit 112, and the detection part 151 is stopped when Vcc' is less than Vx0+ΔVcc. That is, the power source voltage Vcc' (minimum operation power source voltage Vx) at a point of time that the detection part 151 is stopped is increased from Vx0 to Vx0+Δvcc and, as shown in Fig. 20, the input/output characteristic curve (CB) is shifted leftward as indicated by a curve CB'. Accordingly, by detecting a change in the minimum operation power source voltage Vx, it is possible to detect abnormality that any one of the conductive lines is in a high resistance state.

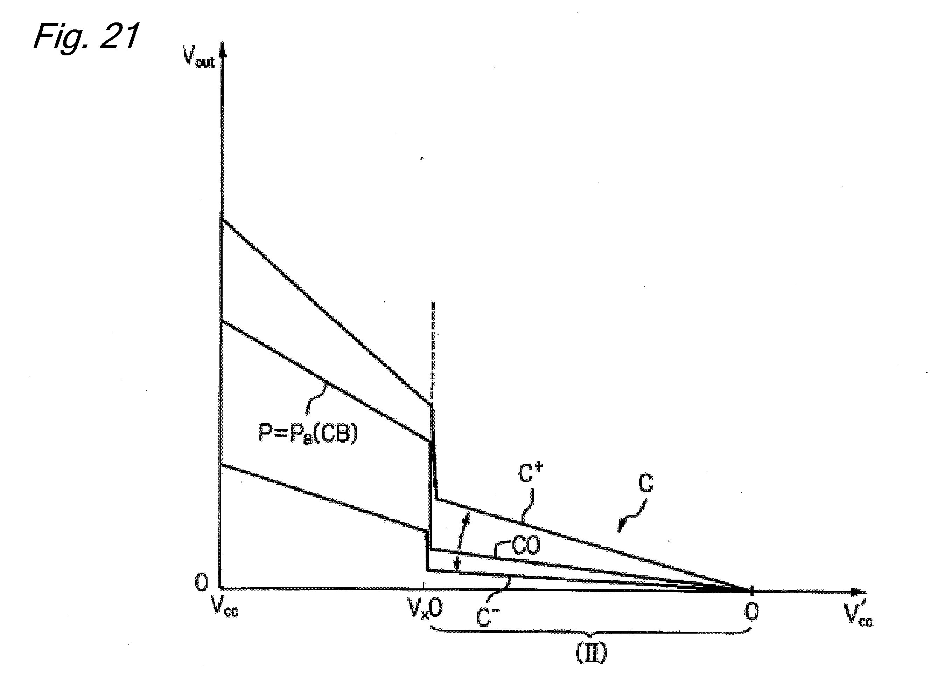

Secondary, as shown in Fig. 21, abnormality in the detection circuit 112 is detected based on whether or not an input/output characteristic (C) of the detection circuit 112 when the power source voltage Vcc' is less than the minimum operation power source voltage Vx agrees with the input/output characteristic curve C0 in a normal state which becomes the reference. When the power source voltage Vcc' is less than the minimum operation power source voltage Vx0, the detection part 151 (Fig. 17) is not operated, and an input/output characteristic of the detection circuit 112 is determined irrelevant to the pressure value P and hence, it is possible to detect abnormality in the detection circuit 112 irrelevant to a pressure value.

When abnormality occurs in the correction circuit 152 or in the amplifier circuit 153, for example, when a correction value Δv of the correction circuit 152 becomes abnormal or an amplification ratio α of the amplifier circuit 153 becomes abnormal, as shown in Fig. 21, an input/output characteristic of the detection circuit 112 when the power source voltage Vcc' is less than the minimum operation power source voltage Vx0 is shifted upward or downward from a curve or a straight line (C0) in a normal state which becomes the reference (curve C+ or C-). That is, by comparing an input/output characteristic or an output signal Vout of the detection circuit 112 when the power source voltage Vcc' is less than the minimum operation power source voltage Vx0 with the input/output characteristic C0 or the output signal in a normal state which becomes the reference, abnormality in the detection circuit 112 can be detected. Here, when the power source voltage Vcc' is 0V (Vcc'=0V), the output signal Vout becomes 0 (Vout=0) and hence, the input/output characteristic curve passes the origin ((Vcc', Vout)=(0, 0)).

[Abnormality detection processing]

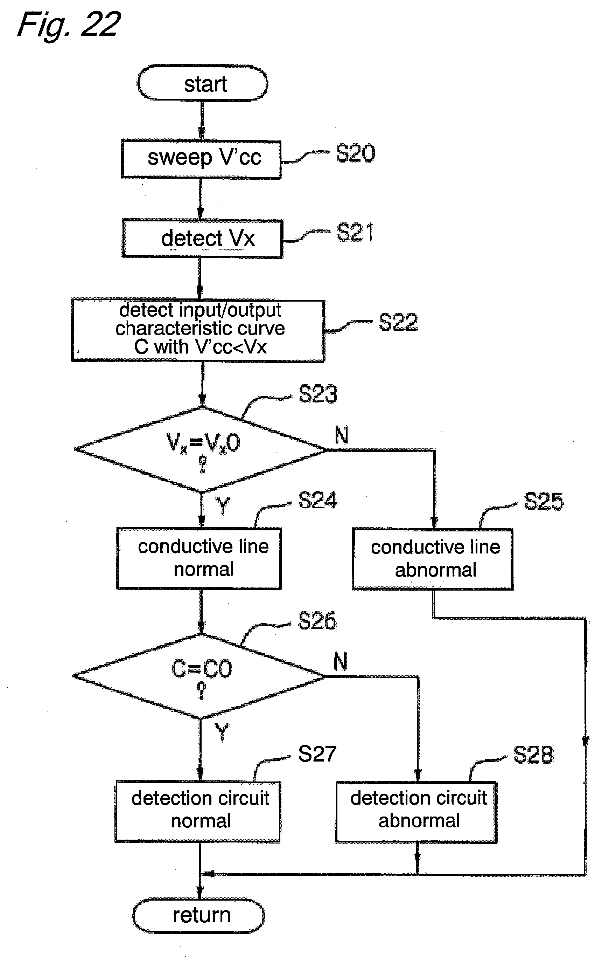

Fig. 22 is a flowchart for explaining the abnormality detection processing of the detection circuit 112 according to the fourth embodiment.

The abnormality detection part 220b sweeps the power source voltage Vcc' from Vcc to 0 as indicated on an axis of abscissas of a graph in Fig. 19 by controlling the power source voltage control circuit 240 (step S20), and based on a change in an output signal Vout, detects a minimum operation power source voltage Vx at which the detection part 151 stops (step S21), and detects an input/output characteristic curve C or an output signal Vout of the detection circuit 112 when the power source voltage Vcc' is less than the minimum operation power source voltage Vx is detected (step S22). Although the explanation is made with respect to the case where the power source voltage Vcc' is swept from Vcc to 0V in this embodiment, the power source voltage Vcc' may be changed from a voltage lower than Vcc within a range where the minimum operation power source voltage Vx can be detected. Here, the minimum operation power source voltage Vx(=Vx0) (reference value) when a conductive line is in a normal state and the input/output characteristic curve C0 or a value of the output signal Vout with the power source voltage Vcc' being less than Vx0 when the detection circuit 112 is in a normal state are stored in the detection circuit 112 in advance.

In step S23, the minimum operation power source voltage Vx which is detected in step S21 and Vx0 (reference value) are compared with each other. When both of Vx and Vx0 agree with each other, it is determined that the conductive line is in a normal state (step S24). On the other hand, when the minimum operation power source voltage Vx and Vx0 (reference value) are different from each other in step S23 (see Fig. 20), it is determined that the conductive line is in an abnormal state (step S25).

In step S26, the input/output characteristic curve C which is detected in step S22 is compared with the reference curve C0. When both the input/output characteristic curve C and the reference curve C0 agree with each other, it is determined that the detection circuit 112 is in a normal state (step S27). On the other hand, when the input/output characteristic curve C is different from the reference curve C0 in step S26 (see Fig. 21), it is determined that the detection circuit 112 is in an abnormal state (step S28).

To consider a case where the input/output characteristic curve C0 when the power source voltage Vcc' is less than the minimum operation power source voltage Vx0 is formed of a straight line, a value of Vout when the power source voltage Vcc' is less than the minimum operation power source voltage Vx is detected at one point in step S22, and a detected value of Vout may be compared with the reference value in step S26.

According to the abnormality detection processing of this embodiment described above, based on the minimum operation power source voltage Vx of the detection part 151 which is decided irrelevant to a pressure value, abnormality caused by a high resistance state of the conductive line which connects the detection circuit 112 with the external circuit can be detected, and also based on the input/output characteristic of the detection circuit 112 when the power source voltage Vcc' is less than the minimum operation power source voltage Vx, abnormality in the detection circuit 112 per se can be detected.

According to the abnormality detection processing of this embodiment, by making use of the area of the input/output characteristic irrelevant to the pressure value, abnormality detection processing of the detection circuit 112 can be also executed even when a value of the peripheral environment per se (pressure value and the like) is not known.

According to the abnormality detection processing of this embodiment, also even when a pressure value is frequently changed, the abnormality detection processing of the detection circuit 112 and the conductive line can be executed irrelevant to the pressure value. Further, abnormality caused by a high resistance state of the conductive line can be detected without adding a monitoring line.

Although the explanation has been made heretofore by taking the detection circuit which detects a pressure as an example, this embodiment is applicable to an arbitrary detection circuit such as a detection circuit for detecting a temperature, a speed, acceleration, humidity or the like.

[Embodiment 5]

According to a method of detecting abnormality of the fourth embodiment, the minimum operation power source voltage Vx at which the detection part 151 (Fig. 17) is stopped is used and hence, in an actual operation, the abnormality of the correction circuit 152 and the amplifying circuit 153 in the detection circuit 112 excluding the detection part 151 is detected. To the contrary, the abnormality detection processing of the detection circuit 112 according to the third embodiment corresponds to the execution of the abnormality detection processing using an input/output characteristic of the region (I) of not less than the minimum operation power source voltage Vx in Fig, 19 and hence, the presence or the non-presence of the abnormality in the whole detection circuit 112 can be detected. Accordingly, in this embodiment, the abnormality detection processing for the detection circuit 112 per se is executed by the method of detecting abnormality according to the third embodiment, and the abnormality detection processing for a conductive line which connects the detection circuit 112 to an external circuit is executed by the method of detecting abnormality according to the fourth embodiment.

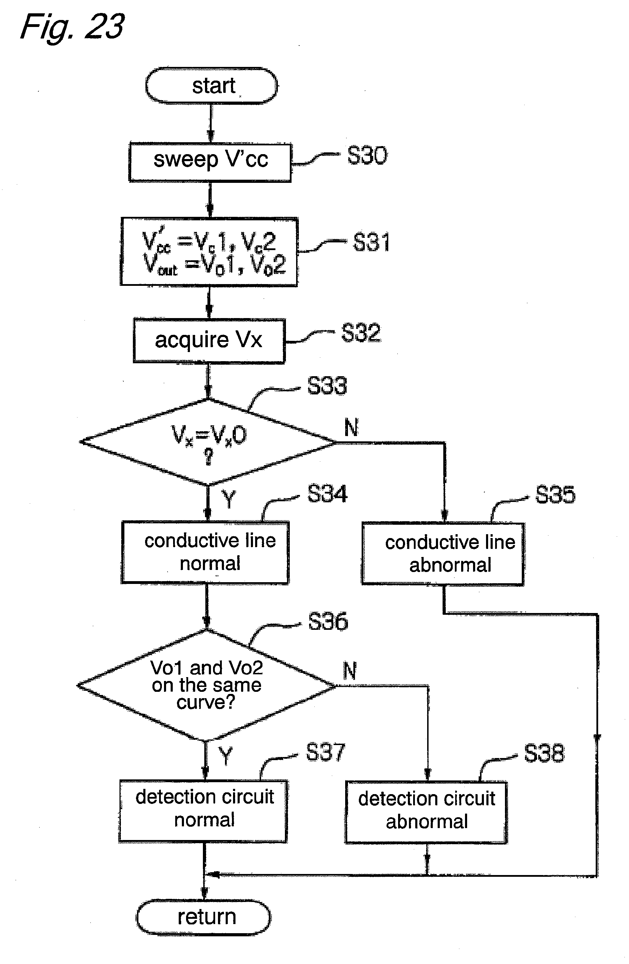

Fig. 23 is a flowchart for explaining the abnormality detection processing of the detection circuit according to the fifth embodiment. In the flowchart, the abnormality detection processing of the detection circuit 112 per se is executed by the method of detecting abnormality according to the third embodiment, and the abnormality detection processing of the conductive line is executed by the method of detecting abnormality according to the fourth embodiment. In the explanation made hereinafter, an abnormality detection function of a processing part 220 of this embodiment is referred to as an abnormality detection part 220c (not shown in the drawing).

The abnormality detection part 220c controls a power source voltage control circuit 240, sweeps a power source voltage Vcc' from Vcc to 0 as indicated on an axis of abscissas in a graph shown in Fig. 19 (step S30), and detects output signals Vout (=Vo1, Vo2) at the power source voltage Vcc' (=Vc1, Vc2) (step S31) and also detects a minimum operation power source voltage Vx at which the detection part 151 stops (step S32). The processing in step S31 corresponds to step S10 and step S11 shown in Fig. 12 and Fig. 14. Further, the diagnosis of the detection circuit 112 may be executed after confirming a state where a pressure value is not changed by adding processing in step S12 and step S13 shown in Fig. 12 and Fig. 14.

In step S33, the minimum operation power source voltage Vx detected in step S32 and Vx0 (reference value) are compared with each other, and it is determined that a conductive line is in a normal state when both power source voltages agree with each other (step S34) and it is determined that the conducive line is in an abnormal state when both power source voltages do not agree with each other (step S35).

In step S36, the abnormality detection part 220c determines whether or not the output signals Vout (=Vo1,Vo2) detected in step S31 are on the same input/output characteristic curve, for example, whether the relationship of Vo1/Vo2 = Vc1/Vc2 is satisfied (see steps S14, S14a in Fig. 12 and Fig. 14). When the output signals Vout (=Vo1,Vo2) are on the same input/output characteristic curve, the abnormality detection part 220c determines that the detection circuit 112 is in a normal state (step S37), while when the output signals Vout (=Vo1,Vo2) detected in step S31 are not on the same input/output characteristic curve, the abnormality detection part 220c determines that the detection circuit 112 is in an abnormal state (step S38).

According to the abnormality detection processing of this embodiment, without adding a monitoring line, abnormality caused by a high resistance state of the conductive line can be detected, and also the presence or non-presence of abnormality in the whole detection circuit 112 including the detection part 151 can be detected based on the input/output characteristic of the detection circuit 112 when the power source voltage Vcc' is not less than Vx.

[Other embodiments]

The abnormality detection processing of the detection circuit 112 per se may be executed using the method of the fourth embodiment, and the abnormality detection processing of the conductive line may be executed using the method through the monitoring line of the first and second embodiments. In this case, using the method through the monitoring line, it is possible to specify the conductive line on which abnormality occurs, and it is also possible to execute the abnormality detection processing of the detection circuit 112 in a peripheral environment where pressure is frequently changed.

Further, both the abnormality detection processing of the detection circuit 112 per se according to the third embodiment and the abnormality detection processing of the detection circuit 112 per se according to the fourth embodiment may be executed. In this case, abnormality in the whole detection circuit including the detection part can be detected by the abnormality detection processing of the third embodiment in a state where no pressure change takes place, and abnormality in the detection circuit excluding the detection part can be detected by the abnormality detection processing of the fourth embodiment in a state where the pressure is frequently changed. Accordingly, it is possible to more surely detect abnormality in the detection circuit 112.

By combining the abnormality detection processing of the conductive line by the fourth embodiment with the abnormality detection processing of the detection circuit 112 per se by the third embodiment and the abnormality detection processing of the detection circuit 112 per se by the fourth embodiment, it is possible to easily and surely perform systematic abnormality detection of the detection circuit 112 including the detection of abnormality in the conductive line which connects the detection circuit 112 with the external circuit.

By combining the abnormality detection processing of the detection circuit 112 per se by the third embodiment and the abnormality detection processing of the detection circuit 112 per se by the fourth embodiment with the abnormality detection processing of the conductive line by the first and second embodiments and the abnormality detection processing of the conductive line by the fourth embodiment, it is possible to further surely perform the systematic abnormality detection of the detection circuit 112 including the abnormality detection of the conductive line which connects the detection circuit 112 and the external circuit with each other.

Further, the technical concept of the present invention is not limited to the abnormality detection of an electric circuit such as a detection circuit and is also applicable to the abnormality detection of other electric devices such as an electrically-operated motor or an electronic device. For example, in a case where an electrically-operated motor is rotated at a high speed with the supply of a predetermined power source voltage Vcc'(=Vcc), that is, a sufficiently high power source voltage, even when the electrically-operated motor is brought into a high frictional state because of a malfunction of a bearing or the like, a change of an output rotational speed of the electrically-operated motor is small and hence, it is difficult to detect the malfunction. On the other hand, when the supplied power source voltage Vcc' is decreased (when the rotational speed of the electrically-operated motor is decreased), the rotational speed of the electrically-operated motor is remarkably lowered in a high frictional state compared to a normal state. Accordingly, a detected value of the rotation speed is compared to a reference value by decreasing the power source voltage Vcc to a power source voltage Vy (<Vcc) at which the rotational speed of the electrically-operated motor remarkably differs between a normal state and a high frictional state. In this case, a value of the power source voltage Vy(<Vcc) at which the rotational speed of the electrically-operated motor remarkably differs between a normal state and a high frictional state and a value of the rotational speed R0 (reference value) with respect to Vcc'(=Vy) when the electrically-operated motor is in a normal state are measured in advance. The abnormality detection processing is performed as follows. During the operation of the electrically-operated motor, the power source voltage is decreased from Vcc to Vy and a rotational speed R of the electrically-operated motor is detected. When the detected value R agrees with the reference value R0, it is determined that "the electrically-operated motor is in a normal state", while when the detected value R does not agree with the reference value R0, it is determined that "the electrically-operated motor is in an abnormal state".

The abnormality can be also detected by detecting a value of the power source voltage Vcc' at which the electrically-operated motor starts, that is, a value of the power source voltage Vcc' at which the rotation of the electrically-operated motor is started. When the electrically-operated motor is brought into a high frictional state because of a malfunction of a bearing or the like, the power source voltage at which the electrically-operated motor is started (starting voltage) is increased from a value Vcc at a normal state (Vcc→Vcc+→ΔVcc). Accordingly, when a starting voltage Vst of the electrically-operated motor is detected and the detected value Vst agrees with the reference value Vcc, it is determined that "the electrically-operated motor is in a normal state". On the other hand, when the detected value Vst does not agree with the reference value Vcc, it is determined that "the electrically-operated motor is in an abnormal state". Abnormality in the electrically-operated motor can be detected in this manner.

(Sixth embodiment)

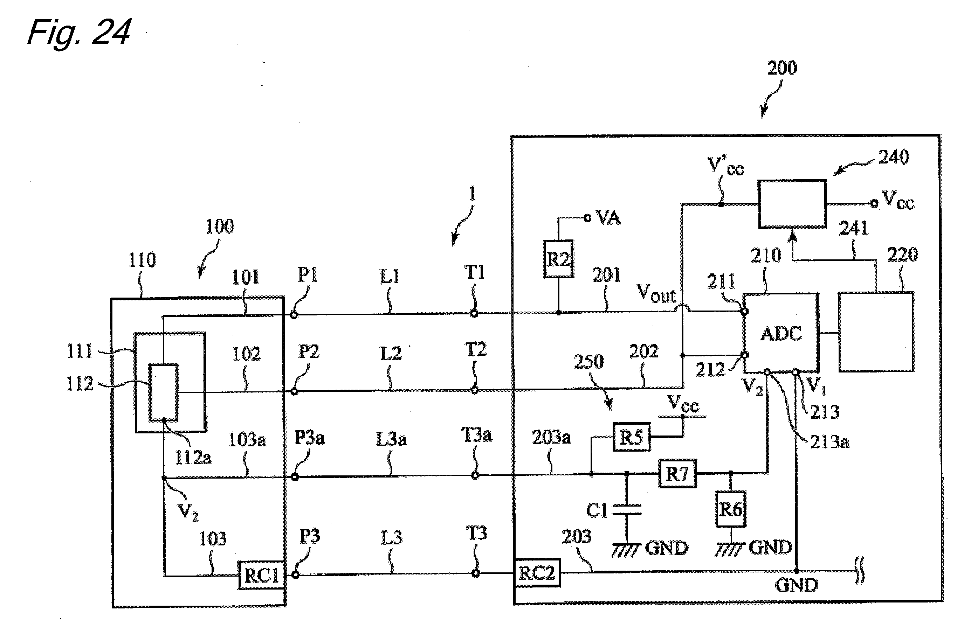

Fig. 24 shows a circuit diagram of a detection system according to a sixth embodiment. In this embodiment, constitutions identical with the constitutions of the above-mentioned embodiments are given same symbols, and the detailed explanation of these constitutions is omitted. Hereinafter, parts having the constitution different from the constitution of the above-mentioned embodiments are explained in detail.

The detection system includes a disconnection detection circuit 250 which is interposed on a monitoring line 203a connected to a monitoring line 203 in the inside of a processing circuit 200.

The detection circuit 250 includes: a resistance R5 which is interposed between the monitoring line 203a and a power source voltage Vcc, a resistance R6 which is interposed between the monitoring line 203a and a ground potential GND, a capacitor C1 which is interposed between the monitoring line 203a and the ground potential GND parallel to the resistance R6, and a resistance R7 which is interposed on a middle portion of the monitoring line 203a and is connected to the resistance R5 and the resistance R6 in series. That is, in the inside of the processing circuit 200, the monitoring line 203a is connected to the power source voltage Vcc through the resistance R5, and is connected to the ground potential GND through the resistance R6. The monitoring line 203a is also connected to the ground potential GND through the capacitor C1 connected to the resistance R6 in parallel. The resistance R7 is interposed on the monitoring line 203a in series, and one end of the resistance R7 is connected to the first capacitor C1 while the other end of the resistance R7 is connected to the resistance R6. In the disconnection detection circuit 250, the power source voltage Vcc is connected to the ground potential GND through the resistance R5, the resistance R7 and the resistance R6, and is connected to the ground potential GND through the resistance R5 and the capacitor C1. Here, the capacitor C1 is provided for stabilizing a potential of the monitoring line 203a. The resistance R7 is provided for limiting an electric current which flows into a ground terminal 213a of the ADC210.

In Fig. 24, symbols RC1, RC2 indicate contact resistances at electrodes or terminals and resistance components of conductive lines. The RC1 includes a contact resistance between a ground electrode P3 of a detection device 100 and a ground line 103, a contact resistance between the ground electrode P3 of the detection device 100 and a ground line L3, a resistance component between the ground electrode P3 of the detection device 100 and a connection point (V2'), and a resistance component on the ground line L3. The RC4 includes a contact resistance between a ground terminal T3 of the processing device 200 and the ground line L3, a contact resistance between the ground terminal T3 of the processing device 200 and the ground line 203, and a resistance component on the ground line 203.

Assuming a case where the contact resistances RC1, RC2 are 0 (when it is considered that resistance values of paths formed of the ground lines 203, L3, 103 from the ground potential GND to the connection point (V2') are substantially 0), in the disconnection detection circuit 250 of the processing circuit 200, the capacitor C1 is charged with an electric current from the power source voltage Vcc through the resistance R5 and, after the charge of the capacitor C1 is finished, the electric current from the power source voltage Vcc flows into the ground potential GND through the monitoring lines 203a, L3a, 103a and the ground lines 103, L3, 203. In this case, the electric current from the power source voltage Vcc does not flow into a resistance R7 side so that a detection voltage V2 which is inputted to a monitoring terminal 213a of an ADC210 from the monitoring line 203a assumes the same potential (0V) as the ground potential GND.

Assuming a case where the contact resistances RC1, RC2 are not 0 (when it is not considered that resistance values of paths formed of the ground lines 203, L3, 103 from the ground potential GND to the connection point (V2') are substantially 0), the potential difference is generated between a potential V2' at the connection point and the ground potential GND of the processing circuit 200. Accordingly, the potential difference is also generated between a potential at a ground terminal 112a of the detection circuit 112 (the same potential as the potential V2'at the connection point) and the ground potential GND of the processing circuit 200. In this embodiment, based on the detection voltage V2 indicative of a resistance state of the ground line (103, L3, 203), the influence which a high resistance state of the ground line exerts on the behavior of the detection circuit 112 (output voltage Vout) is corrected.

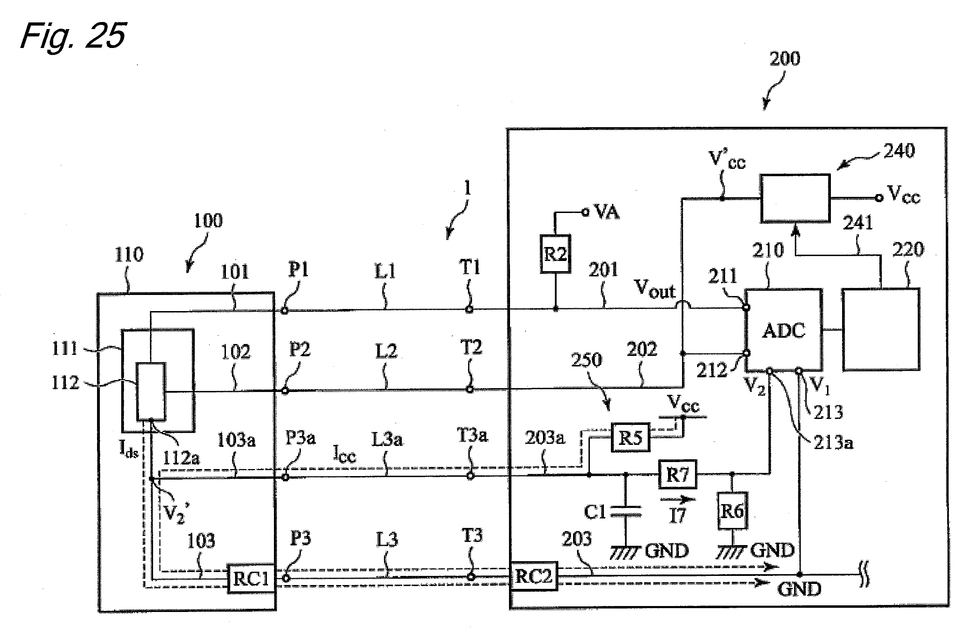

As shown in Fig. 25, when the contact resistances RC1, RC2 are not 0, the potential V2' at the connection point is expressed by following formulae (3) to (5) using an electric current Ids which flows through the ground lines (103, L3, 203) from the detection circuit 112 and an electric current Icc which flows through the resistance R5, the monitoring lines (203a, L3a, 103a), the ground lines (103, L3, 203) from the power source voltage Vcc.

$$V2=(Ids+Icc)*(RC1+RC2) \dots \dots \quad (3)$$

$$Ids=10mA \dots \dots \dots \dots \dots \dots \quad (4)$$

$$Icc=Vcc/(R5+RC1+RC2) \dots \dots \dots \quad (5)$$

Here, Ids is set to 10mA (a constant value) which is a value of an electric current which typically flows into the detection circuit 112.

As indicated in the formulae (3) to (5), the potential V2' at the connection point is a value proportional to RC1+RC2. Assuming the resistance values of the resistances R5, R7, R6 as R5=1[kΩ], R7=10[kΩ], R6=15[kΩ] respectively, for example, when the contact resistance RC1+RC2 is sufficiently small compared to the resistance value of the resistance R7, an electric current I7 which flows through the resistance R7 is sufficiently small compared to the electric current Ids and hence, the electric current I7 can be ignored. In one example, the electric current Icc is several mA, and the electric current I7 which flows through the resistance R7 is approximately 1μA. Accordingly, a voltage step-down amount at the resistance R7 can be ignored and hence, it is considered that the detection voltage V2 which is inputted to the monitoring terminal 213a of the ADC 210 agrees with the potential V2' at the connection point (V2= V2'). As a result, a state of the resistance component RC1+RC2 of the ground line can be monitored using the detection voltage V2.

Since the detection voltage V2 agrees with the potential V2' at the connection point, the deviation of the potential at the ground terminal of the detection circuit 112 can be corrected using the detection voltage V2. To be more specific, as described later, an output voltage Vout and an input voltage Vcc of the detection circuit 112 are corrected using the detection voltage V2 (ΔV=V2-V1).

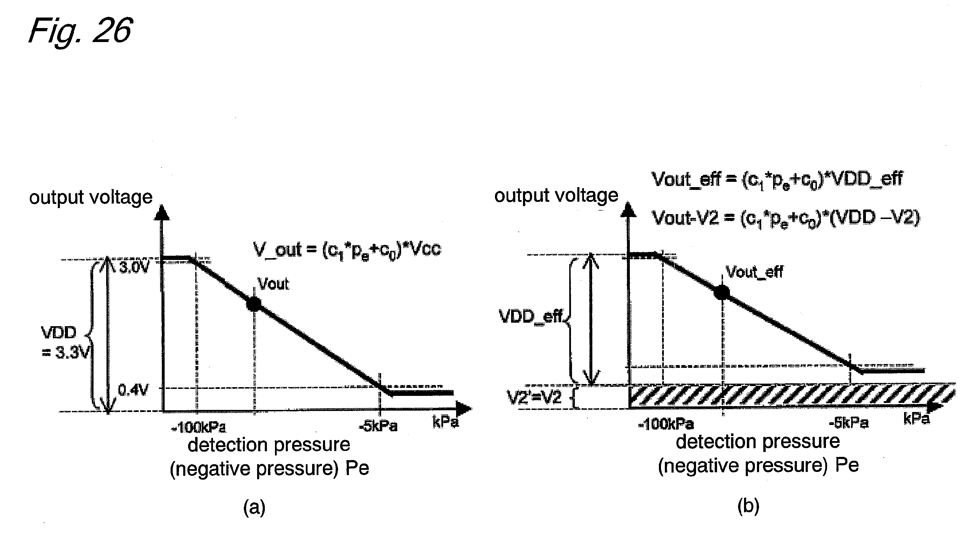

Fig. 26 is an explanatory view for explaining the processing which corrects the output voltage Vout of the detection circuit 112 using the detection voltage V2. Fig. 26(a) shows a characteristic curve indicating the relationship between the output voltage Vout and the detection pressure (negative pressure) when the potential V2' at the connection point agrees with the ground potential (0V). Fig. 26(b) shows the characteristic curve when the voltage V2' at the connection point is elevated because of the contact resistance RC1+RC2 of the ground line.

Here, the detection circuit 112 is constituted of a pressure detection circuit, and the explanation is made by taking a type of detection circuit in which the output voltage Vout is linearly lowered corresponding to the increase of a value of a negative pressure as an example. A pressure detection range of the pressure detection circuit 112 is, as shown in Fig. 26(a) and (b), approximately from -100kPa to - 5kPa. When Vcc(=5[V]) is supplied to the pressure detection circuit 112, the pressure detection circuit 112 outputs the output voltage Vout which falls within a range from 0.3[V] to 3.3 [V] .

When the potential V2'at the connection point agrees with the ground potential GND, the characteristic curve of the pressure detection circuit 112 takes a curve shown in Fig. 26(a). In the characteristic curve in Fig. 26(a), a zone where the output voltage Vout is linearly lowered is expressed by a formula (6).

$$Vout=(c1*pe+c0)*VDD \dots \dots \dots \dots \quad (6)$$

Here, Vout is an output voltage [V] of the pressure detection circuit 112, and pe is a detection pressure (negative pressure: [kPa]). c1, c0 are constants which are decided depending on the specification of the pressure detection circuit 112. VDD is a reference voltage which decides the inclination of the characteristic curve and corresponds to an upper limit value [V] of a pressure detection range of the pressure detection circuit 112 (3.3[V] in this example). The reference voltage VDD is set in advance corresponding to a kind of the pressure detection circuit 112 and corresponding to a magnitude of a value of the power source voltage Vcc.

Fig. 26(b) shows a characteristic curve of a case where the potential V2' at the connection point (detection voltage V2) is elevated because of the contact resistance Rc1+RC2 of the ground line. Here, the output voltage Vout of the pressure detection circuit 112 is detected as a value which is offset in the increasing direction by V2'(=V2) compared to the case where V2'is 0 (V2'=0). In the same manner, the reference voltage VDD is also detected as a value which is offset in the increasing direction by V2'(=V2) compared to a case where V2'is V2 and 0 (V2'=V2=0). Accordingly, the processing which corrects the output voltage Vout and the reference voltage VDD by only the offset amount V2' (=V2) is executed. As described previously, since the potential V2'at the connection point can be considered as equal to the ground potential detection voltage V2, the output voltage Vout and the reference voltage VDD are corrected as expressed by a formula (7) using the correction amount V2. The output voltage Vout and the reference voltage VDD after the correction are respectively assumed as an effective output voltage Vout_eff and an effective reference voltage VDD eff respectively.

$$Vout\_eff=Vout-V2$$

$$VDD\_eff=VDD-V2 \quad .......................... \quad (7)$$

By using Vout_eff and VDD_eff in the formula (7) in the formula (6) in place of Vout and VDD, the relationship expressed by a formula (8) is established.

$$Vout\_eff=(c1*pe+c0)* \ VDD\_ef \quad ............ \quad (8)$$

Accordingly, by calculating the detection pressure pe by the formula (8) using the effective output voltage Vout_ eff and the effective reference voltage VDD_eff which are obtained by correcting the output voltage Vout and the reference voltage VDD of the pressure detection circuit 112 using the detection voltage V2 respectively, it is possible to calculate the detection pressure pe which compensates for a contact resistance amount of the ground line. Due to this processing, even when the unexpected elevation of the resistance value occurs on the ground line, it is possible to compensate for the influence which the resistance value on the ground line exerts on the detection pressure pe.

Assuming a case where the monitoring lines 103a, L3a, 203a are disconnected so that the monitoring lines 103a, L3a, 203a are brought into an excessively high resistance state, in the disconnection detection circuit 250, an electric current from the power source voltage Vcc flows toward only a resistance R7 side (Icc=0). Accordingly, a detection voltage V2 which is inputted to the monitoring terminal 213a of the ADC 210 becomes a voltage applied to the resistance R6. The voltage of the resistance R6 is a voltage obtained by dividing the power source voltage Vcc by the resistance R5+R7 and the resistance R6, and is expressed by a formula (9).

$$V2=Vcc*R6/(R5+R7+R6) \quad ...................... \quad (9)$$

For example, V2 becomes 2.88[V] (V2=2.88[V]) when Vcc, R5, R7 and R6 are set such that Vcc=5[V], R5=1 [kΩ], R7=10 [kΩ] and R6=15[kΩ]. In this case, a value of V2 may be monitored by setting a threshold value of V2 when the monitoring line is disconnected to 2.88[V] (Vth=2.88[V]), for example.

The specific processing in the processing device 200 is as follows. The ADC 210 outputs a digital signal corresponding to analogue signals V1, V2 which are inputted to the ADC 210. A processing part 220 calculates ΔV(=V2-V1) based on the digital signals V1, V2. When ΔV falls within a range of -10mV<ΔV<10mV, the processing part 220 determines that "The ground line is in a normal state", when ΔV falls within a range of 10mV≤ΔV≤Vth, the processing part 220 determines that "The ground line is in a high resistance state", and when ΔV satisfies the relationship of Vth<Δv, the processing part 220 determines that "The monitoring line is disconnected". In this embodiment, although it is determined that V2'(=V2) agrees with a predetermined value (0V) when ΔV falls within a range of -10mV<AV<10mV, the range may be suitably decided corresponding to the resolution of the ADC210.

When ΔV satisfies the relationship of ΔV≤Vth, the processing part 220 corrects an output voltage Vout and a reference voltage VDD by only ΔV(=V2) by the formula (7) and calculates the effective output voltage Vout_eff and the effective reference voltage VDD_eff. Then, the processing part 220 calculates a detection pressure pe by the formula (8) using the effective output voltage Vout_eff and the effective reference voltage VDD_eff.

When the relationship of -10mV<ΔV<10mV (ΔV being approximately 0) is established, the detection pressure pe may be calculated by the formula (6) without correcting the output voltage Vout and the reference voltage VDD.

According to the above-mentioned sixth embodiment of the present invention, the detection pressure pe which compensates for the contact resistance amount of the ground line can be calculated by correcting the output voltage Vout and the reference voltage VDD using the potential V2'(=V2) at the connection point. Due to this processing, even when an unexpected elevation of the resistance value occurs on the ground line, it is possible to compensate for the influence which the resistance value on the ground line exerts on the detection pressure pe. Accordingly, when a high resistance state of the ground line is detected, the detection pressure Pe can be corrected corresponding to a resistance state of the ground line so that the accurate detection of pressure can be continued while preventing the system from being stopped.

Further, by arranging the disconnection detection circuit 250 which includes the resistances R5, R6 interposed between the monitoring line and the power source voltage Vcc and between the monitoring line and the ground potential GND respectively in the inside of the processing device 200, the disconnection of the monitoring line per se for monitoring a resistance state of the ground line can be detected without adding the special constitution to the detection device 110.

The above-mentioned correction processing of the output voltage Vout and the reference voltage VDD is also applicable to the above-mentioned first embodiment. To be more specific, the output voltage Vout and the reference voltage VDD may be corrected using the ΔV which is calculated in the first embodiment as a correction amount.

In the above-mentioned first to sixth embodiments, the explanation has been made mainly with respect to the detection system. However, the present invention is not limited to the detection system and is applicable to an arbitrary electric system provided that the electric system has the constitution where the power source supply or the signal communication is performed among a plurality of circuits.

The present application is the application which claims the priority from the international patent application PCT/JP2009/57606, and is filed as the priority claiming application where claims 9 to 29 of the present application correspond to claims 1 to 21 of the basic application and claims 1 to 8 are newly added.

EXPLANATION OF SYMBOLS

1: detection system
100: detection device (sensor device)
200: processing device (ECU)
101, L1, 201: detection signal line
102, L2, 202: power source line
103, L3, 203: ground line
101a to 103a, L1a to L3a, 201a to 203a: monitoring line
P1 to P3, P1a to P3a: electrode
T1 to T3, T1a to T3a: terminal
110: housing
111: sensor chip
112: detection circuit
112a: ground terminal
151: detection part
152: correction circuit
153: amplifying circuit
210: analogue digital converter (ADC)
220: processing part
220a, 220b: abnormality detection part
R2, R3: resistance
Vcc: power source voltage source, power source voltage
230, 240: power source voltage control circuit
231: switching circuit
232, 241: control line
250: disconnection detection circuit
RL: voltage step-down resistance

**Claims**

**1.** An electric system comprising:

    a first electric circuit (112),
    a ground line (L3, 103) which is connected to a ground terminal of the first electric circuit (112), and

a monitoring conductive line (L3a, 103a) which is electrically connected to the ground line and detects a potential (V2') at a connection point with the ground line, wherein

the electric system corrects a behavior (Vout) of the first electric circuit (112) based on a detection voltage (V2) through the monitoring conductive line.

2. The electric system according to claim 1, wherein the monitoring conductive line (L3a, 103a) is connected to a power source voltage (Vcc) through a first resistance (R5), and is also connected to a ground potential (GND) through a second resistance (R6), and

abnormality in the monitoring conductive line per se is detected by detecting a voltage of the second resistance as the detection voltage (V2).

3. The electric system according to claim 2, wherein when the detection voltage (V2) through the monitoring conductive line is smaller than a first threshold value (Vth), the correction of the behavior (Vout) of the first electric circuit (112) is executed using the detection voltage (V2) through the monitoring conductive line, and

the determination that the monitoring conductive line is disconnected is made when the detection voltage (V2) through the monitoring conductive line becomes the first threshold value or more.

4. The electric system according to claim 2, wherein when the detection voltage (V2) through the monitoring conductive line is smaller than a second threshold value which is smaller than the first threshold value, the determination that the ground line is in a normal state is made and the correction of the behavior (Vout) of the first electric circuit (112) is not executed,

when the detection voltage (V2) through the monitoring conductive line is not less than the second threshold value and less than the first threshold value, the correction of the behavior (Vout) of the first electric circuit (112) is executed using the detection voltage (V2) through the monitoring conductive line, and

when the detection voltage (V2) through the monitoring conductive line becomes not less than the first threshold value, the determination that the monitoring conductive line is disconnected is made.

5. The electric system according to any one of claims 1 to 4, wherein the first electric circuit (112) is a detection circuit which detects a specific kind of physical quantity, and corrects an output voltage (Vout) of the detection circuit (112) using the detection voltage (V2) through the monitoring conductive line.

6. The electric system according to claim 5, wherein the correction of a physical quantity to be detected is executed by correcting the output voltage (Vout) of the detection circuit (112) and an upper limit value (VDD) of the output voltage (Vout) using the detection voltage (V2) through the monitoring conductive line.

7. The electric system according to claim 5, wherein the detection circuit (112) is a pressure sensor which detects pressure in a negative pressure booster which assists a braking device of a vehicle, and the output voltage (Vout) is a pressure detection signal.

8. The electric system according to claim 2, wherein the electric system further includes a third resistance (R7) which is interposed on the monitoring conductive line (L3a, 103a), and one end of the third resistance (R7) is connected to the first resistance (R5), and the other end of the third resistance (R7) is connected to the second resistance (R6).

9. An abnormality detection device for a detection circuit which detects abnormality in a detection circuit (112) which detects a specific kind of physical quantity, wherein the abnormality detection device includes an abnormality detection part (220a) which changes magnitude of a power source voltage (Vcc') which is supplied to the detection circuit (112), and detects abnormality in the detection circuit based on an output signal (Vo2) from the detection circuit at a power source voltage (Vc2) after the change of the magnitude of the power source voltage (Vcc').

10. The abnormality detection device for a detection circuit (112) according to claim 9, wherein the abnormality detection part (220a) detects the abnormality in the detection circuit (112) based on whether or not output signals (Vo1, Vo2) from the detection circuit (112) before and after the change of the power source voltage are on an input/output characteristic curve with respect to the same physical quantity (P).

11. The abnormality detection device for a detection circuit (112) according to claim 9, wherein the abnormality detection part (220a) detects the abnormality in the detection circuit (112) based on whether or not the ratio of output signals (Vo1, Vo2) from the detection circuit (112) before and after the change of the power source voltage agrees with the ratio of power source voltages (Vc1, Vc2) before and after the change of the power source voltage.

**12.** The abnormality detection device for a detection circuit (112) according to claim 9, wherein the abnormality detection part (220a) changes the power source voltage to a plurality of voltages (Vc2, Vc3) which differ from each other, and detects the abnormality in the detection circuit (112) based on output signals (Vo2, Vo3) from the detection circuit (112) at the plurality of power source voltages (Vc2, Vc3) after the change.

**13.** The abnormality detection device for a detection circuit (112) according to any one of claims 9 to 12, wherein the abnormality detection part (220a) measures an output signal from the detection circuit (112) with respect to the power source voltage value (Vc1) before the change at least twice at a predetermined time interval, and when the output signals (Vo1, Vo1') agree with each other at least twice, the abnormality detection part (220a) detects the abnormality in the detection circuit based on the output signal (Vo2) from the detection circuit at the power source voltage (Vc2) after the change.

**14.** The abnormality detection device for a detection circuit (112) according to any one of claims 9 to 13, wherein the abnormality detection device includes a power source voltage control part (230) which changes magnitude of a power source voltage (Vcc') which is supplied to the detection circuit (112) in response to a control by the abnormality detection part (220a).

**15.** The abnormality detection device for a detection circuit (112) according to any one of claims 9 to 14, wherein the detection circuit (112) is a pressure sensor which detects pressure in a negative pressure booster which assists a braking device of a vehicle.

**16.** An abnormality detection device which detects abnormality in an electric circuit (112) whose behavior is changed corresponding to a peripheral environment, wherein the abnormality detection device includes an abnormality detection part (220a) which changes magnitude of a power source voltage (Vcc') supplied to the electric circuit (112), and detects abnormality in the electric circuit based on the behavior (Vo2) of the electric circuit at a power source voltage (Vc2) after the change.

**17.** A detection system comprising:

a detection circuit (112) which detects a specific kind of physical quantity;
a processing device (200) which processes an output from the detection circuit (112);
a conductive line (L1, 101; L2, 102; L3, 103) which electrically connects the detection circuit and the processing device with each other; and
a monitoring conductive line (L1a, 101a; L2a, 102a; L3a, 103a) which is electrically connected with the conductive line on the detection circuit (112) side, wherein
a resistance state of the conductive line is detected by detecting a potential at a connection point between the conductive line and the monitoring conductive line using the monitoring conductive line, and
the detection system includes an abnormality detection part (220a) which changes magnitude of a power source voltage (Vcc') supplied to the detection circuit (112), and detects abnormality in the detection circuit (112) based on an output signal (Vo2) from the detection circuit at a power source voltage (Vc2) after the change.

**18.** An electronic system comprising:

a first electric circuit (112) whose behavior is changed corresponding to a peripheral environment;
a second electric circuit (200);
a conductive line (L1, 101; L2, 102; L3, 103) which electrically connects the first electric circuit and the second electric circuit with each other; and
a monitoring signal line (L1a, 101a; L2a, 102a; L3a, 103a) which is electrically connected to the conductive line on the first electric circuit side, wherein
a resistance state of the conductive line is detected by detecting a potential at a connection point between the conductive line and the monitoring signal line through the monitoring signal line, and
the electronic system further includes an abnormality detection part (220a) which changes magnitude of a power source voltage (Vcc') supplied to the first electric circuit (112), and detects abnormality in the first electric circuit (112) based on the behavior (Vo2) of the first electric circuit at a power source voltage (Vc2) after the change.

**19.** An abnormality detection device for a detection circuit (112) including a detection part (151) which detects a specific kind of physical quantity, wherein
the abnormality detection device includes an abnormality detection part (220b) which changes magnitude of a power source voltage (Vcc') supplied to the detection circuit (112), detects an output signal (Vout) of the detection circuit (112) when the power source voltage (Vcc') is less than the power source voltage (Vx) at which the detection part (151) is stopped, and detects abnormality in the detection circuit (112) based on the detected value.

20. The abnormality detection device for a detection circuit (112) according to claim 19, wherein the abnormality detection part (220b), further, detects a resistance state of a conductive line which connects the detection circuit (112) with the outside based on the power source voltage (Vx) at which the detection part (151) is stopped.

21. An abnormality detection device for a detection circuit (112) including a detection part (151) which detects a specific kind of physical quantity, wherein the abnormality detection device includes an abnormality detection part (220b) which changes magnitude of a power source voltage (Vcc') supplied to the detection circuit (112), detects the power source voltage (Vx) at which the detection part (151) is stopped, and detects a resistance state of a conductive line which connects the detection circuit (112) with the outside based on the detected value.

22. An abnormality detection device for an electric circuit (112), wherein the abnormality detection device includes an abnormality detection part (220b) which changes magnitude of a power source voltage (Vcc') supplied to the electric circuit (112), detects an output signal (Vout) of the electric circuit (112) when the power source voltage (Vcc')is less than the power source voltage (Vx) at which a portion (151) included in the electric circuit (112) is stopped, and detects abnormality in the electric circuit (112) based on the detected value.

23. An abnormality detection device for an electric circuit (112), wherein the abnormality detection device includes an abnormality detection part (220b) which changes magnitude of a power source voltage (Vcc') supplied to the electric circuit (112), detects the power source voltage (Vx) at which a portion (151) of the electric circuit (112) is stopped, and detects a resistance state of a conductive line which connects the electric circuit (112) with the outside based on the detected value.

24. An abnormality detection device for a detection circuit (112) which includes a detection part (151) for detecting a specific kind of physical quantity, the abnormality detection device comprising:

a first abnormality detection part (220a) which changes magnitude of a power source voltage (Vcc') supplied to the detection circuit (112), detects an output signal (Vo2) from the detection circuit with respect to a power source voltage (Vc2) after the change within a range of not less than the power source voltage (Vx) at which the detection part (151) is stopped, and detects abnormality in the detection circuit based on the detected value; and
a second abnormality detection part (220b) which detects the power source voltage (Vx) at which the detection part (151) is stopped, and detects a resistance state of a conductive line which connects the detection circuit (112) with the outside based on the detected value.

25. An abnormality detection device for an electric circuit which detects abnormality in an electric circuit (112) including a circuit part (151) whose behavior is changed corresponding to a peripheral environment, the abnormality detection device comprising:

a first abnormality detection part (220a) which changes magnitude of a power source voltage (Vcc') supplied to the electric circuit (112), detects an output signal (Vo2) from the detection circuit with respect to a power source voltage (Vc2) after the change within a range not less than the power source voltage (Vx) at which the circuit part (151) is stopped, and detects abnormality in the electric circuit based on the detected value; and
a second abnormality detection part (220b) which detects the power source voltage (Vx) at which the circuit part (151) is stopped, and detects a resistance state of a conductive line which connects the electric circuit (112) with the outside based on the detected value.

26. A detection system comprising:

a detection circuit (112) including a detection part (151) which detects a specific kind of physical quantity; a processing device (200) which processes an output from the detection circuit (112);
a conductive line (L1, 101; L2, 102; L3, 103) which electrically connects the detection circuit and the processing device; and
a monitoring conductive line (L1a, 101a; L2a, 102a; L3a, 103a) which is electrically connected to the conductive line on the detection circuit (112) side, wherein

a resistance state of the conductive line is detected by detecting a potential at a connection point between the conductive line and the monitoring conductive line through the monitoring conductive line, and

the detection system further includes an abnormality detection part (220b) which changes magnitude of a power source voltage (Vcc') supplied to the detection circuit (112), detects an output signal (Vout) of the detection circuit (112) when the power source voltage (Vcc')is less than the power source voltage (Vx) at which the detection part (151) is stopped, and detects abnormality in the detection circuit (112) based on the detected value.

27. An electronic system comprising:

a first electric circuit (112);
a second electric circuit (200);
a conductive line (L1, 101; L2, 102; L3, 103) which electrically connects the first electric circuit and the second electric circuit with each other; and
a monitoring signal line (L1a, 101a; L2a, 102a; L3a, 103a) which is electrically connected to the conductive line on the first electric circuit side, wherein
a resistance state of the conductive line is detected by detecting a potential at a connection point between the conductive line and the monitoring signal line through the monitoring signal line, and
the electronic system further includes an abnormality detection part (220b) which changes magnitude of a power source voltage (Vcc') supplied to the electric circuit (112), detects an output signal (Vout) of the electric circuit (112) when the power source voltage (Vcc')is less than a stop power source voltage (Vx) at which a portion (151) of the electric circuit is stopped, and detects abnormality in the electric circuit (112) based on the detected value.

28. An abnormality detection device for a detection circuit (112) including a detection part (151) which detects a specific kind of physical quantity, the abnormality detection device comprising:

a first abnormality detection part (220a) which changes magnitude of a power source voltage (Vcc') supplied to the detection circuit (112), detects an output signal (Vo2) from the detection circuit with respect to a power source voltage (Vc2) after the change within a range not less than the power source voltage (Vx) at which the detection part (151) is stopped, and detects abnormality in the detection circuit based on the detected value; and
a second abnormality detection part (220b) which detects an output signal (Vout) of the detection circuit (112) when the power source voltage (Vcc')is less than the power source voltage (Vx) at which the detection part (151) is stopped, and detects abnormality in the detection circuit (112) based on the detected value.

29. An abnormality detection device for an electric circuit which detects abnormality in an electric circuit (112) including a circuit part (151) whose behavior is changed corresponding to a peripheral environment, the abnormality detection device comprising:

a first abnormality detection part (220a) which changes magnitude of a power source voltage (Vcc') supplied to the electric circuit (112), detects an output signal (Vo2) from the detection circuit with respect to a power source voltage (Vc2) after the change within a range not less than the power source voltage (Vx) at which the circuit part (151) is stopped, and detects abnormality in the electric circuit based on the detected value; and
a second abnormality detection part (220b) which detects an output signal (Vout) of the electric circuit (112) when the power source voltage (Vcc')is less than the stop power source voltage (Vx) at which the portion (151) of the electric circuit is stopped, and detects abnormality in the electric circuit (112) based on the detected value.

Fig. 1

EP 2 420 851 A1

Fig. 2

EP 2 420 851 A1

EP 2 420 851 A1

## Fig. 3

Fig. 4

EP 2 420 851 A1

Fig. 5

*Fig. 6*

## Fig. 7A

## Fig. 7B

Fig. 8

EP 2 420 851 A1

Fig. 9

EP 2 420 851 A1

Fig. 10

EP 2 420 851 A1

Fig. 11

EP 2 420 851 A1

*Fig. 12*

S10 — $V'_{cc} = V_c 1$
$V_{out} = V_0 1$

S11 — $V'_{cc} = V_c 2$
$V_{out} = V_0 2$

S12 — $V'_{cc} = V_c 1$
$V_{out} = V_0 1'$

S13 — $V_0 1 = V_0 1'$ ?   N

Y

S14 — Vo1 and Vo2 on the same curve?   N

Y

S15 — normal

S16 — abnormal

return

*Fig. 13*

EP 2 420 851 A1

## Fig. 14

```
                    ┌─────────┐
                    │  start  │◄──────────────────────┐
                    └────┬────┘                        │
                         │                             │
        ┌────────────────▼────────────────┐           │
S10 ────┤        V'cc = Vc1                │           │
        │        Vout = Vo1               │           │
        └────────────────┬────────────────┘           │
                         │                             │
        ┌────────────────▼────────────────┐           │
S11 ────┤        V'cc = Vc2                │           │
        │        Vout = Vo2               │           │
        └────────────────┬────────────────┘           │
                         │                             │
        ┌────────────────▼────────────────┐           │
S12 ────┤        V'cc = Vc1                │           │
        │        Vout = Vo1'              │           │
        └────────────────┬────────────────┘           │
                         │                             │
S13 ─────────────◆───────────────◆  N                 │
                  │  Vo1 = Vo1' ? ├──────────────────►─┘
                  ◆───────────────◆
                         │ Y
                         │
S14a ────────────◆───────────────◆  N
                  │  Vo1   Vc1    ├──────────────┐
                  │  ─── = ─── ?  │              │
                  │  Vo2   Vc2    │              │
                  ◆───────────────◆              │
                         │ Y                     │         ┌── S16
                         │                       ▼
        ┌────────────────▼──────┐      ┌─────────────────┐
S15 ────┤      normal           │      │    abnormal     │
        └────────────────┬──────┘      └────────┬────────┘
                         │                       │
                         ◄───────────────────────┘
                         │
                    ┌────▼────┐
                    │ return  │
                    └─────────┘
```

*Fig. 15*

Fig. 16

## Fig. 17

EP 2 420 851 A1

Fig. 18

Fig. 19

EP 2 420 851 A1

*Fig. 20*

Fig. 21

*Fig. 22*

```
                    ┌─────────────┐
                    │    start    │
                    └──────┬──────┘
                           │
                    ┌──────▼──────┐
                    │  sweep V'cc │────── S20
                    └──────┬──────┘
                           │
                    ┌──────▼──────┐
                    │  detect Vx  │────── S21
                    └──────┬──────┘
                           │
              ┌────────────▼────────────┐
              │   detect input/output   │
              │   characteristic curve  │────── S22
              │     C with V'cc<Vx      │
              └────────────┬────────────┘
                           │              S23
                       ╱───▼───╲
                      ╱ Vx=Vx0  ╲────── N ──────────┐
                      ╲    ?    ╱                    │
                       ╲───┬───╱                     │
                         Y │       S24               │    S25
                    ┌──────▼──────┐          ┌────────▼────────┐
                    │ conductive  │          │  conductive     │
                    │ line normal │          │  line abnormal  │
                    └──────┬──────┘          └────────┬────────┘
                           │      S26                 │
                       ╱───▼───╲                      │
                      ╱  C=C0   ╲──── N ──────┐        │
                      ╲    ?    ╱             │        │
                       ╲───┬───╱             │        │
                         Y │    S27          │ S28    │
                    ┌──────▼──────┐   ┌───────▼──────┐│
                    │ detection   │   │ detection    ││
                    │ circuit     │   │ circuit      ││
                    │ normal      │   │ abnormal     ││
                    └──────┬──────┘   └───────┬──────┘│
                           │                  │       │
                           ◄──────────────────┴───────┘
                    ┌──────▼──────┐
                    │   return    │
                    └─────────────┘
```

*Fig. 23*

```
        ┌─────────────┐
        │    start    │
        └─────────────┘
               │
        ┌─────────────┐
        │  sweep V'cc │──── S30
        └─────────────┘
               │
        ┌─────────────┐
        │ V'cc =Vc1,Vc2│──── S31
        │ Vout =Vo1,Vo2│
        └─────────────┘
               │
        ┌─────────────┐
        │  acquire Vx │──── S32
        └─────────────┘
               │         ──── S33
            ╱─────╲
           ╱ Vx=Vx0 ╲         N
           ╲   ?   ╱──────────────┐
            ╲─────╱               │
               │ Y                │
               │ ──S34            │ ──S35
    ┌──────────────┐      ┌──────────────┐
    │conductive line│     │conductive line│
    │    normal     │     │   abnormal    │
    └──────────────┘      └──────────────┘
               │                  │
               │ ──S36            │
            ╱─────╲               │
           ╱Vo1 and Vo2╲    N     │
           ╲on the same╱──────┐   │
           ╲  curve?  ╱       │   │
            ╲─────╱           │   │
               │ Y ──S37      │ ──S38 │
    ┌──────────────┐      ┌──────────────┐
    │detection circuit│   │detection circuit│
    │    normal      │    │   abnormal    │
    └──────────────┘      └──────────────┘
               │                  │
               └──────────────────┘
               │
        ┌─────────────┐
        │   return    │
        └─────────────┘
```

51

## Fig. 24

EP 2 420 851 A1

Fig. 25

EP 2 420 851 A1

## Fig. 26

$$V\_out = (c_1 \cdot p_e + c_0) \cdot Vcc$$

output voltage

3.0V

Vout

VDD = 3.3V

0.4V

-100kPa

-5kPa

kPa

detection pressure
(negative pressure) Pe

(a)

$$Vout\_eff = (c_1 \cdot p_e + c_0) \cdot VDD\_eff$$

$$Vout-V2 = (c_1 \cdot p_e + c_0) \cdot (VDD - V2)$$

output voltage

Vout_eff

VDD_eff

V2'=V2

-100kPa

-5kPa

kPa

detection pressure
(negative pressure) Pe

(b)

EP 2 420 851 A1

<table>
<tr><td colspan="2">**INTERNATIONAL SEARCH REPORT**</td><td>International application No.<br>PCT/JP2010/056701</td></tr>
</table>

**A. CLASSIFICATION OF SUBJECT MATTER**
*G01R31/00*(2006.01)i, *G01R31/02*(2006.01)i

According to International Patent Classification (IPC) or to both national classification and IPC

**B. FIELDS SEARCHED**

Minimum documentation searched (classification system followed by classification symbols)
G01R

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 60-227174 A  (Honda Motor Co., Ltd.),<br>12 November 1985 (12.11.1985),<br>page 2, lower right column to page 4, lower<br>left column; fig. 3<br>(Family: none) | 1<br>2-29 |
| A | JP 61-251777 A  (Nippondenso Co., Ltd.),<br>08 November 1986 (08.11.1986),<br>entire text; all drawings<br>(Family: none) | 1-29 |
| A | JP 6-273429 A  (Sumitomo Electric Industries,<br>Ltd.),<br>30 September 1994 (30.09.1994),<br>entire text; all drawings<br>(Family: none) | 1-29 |

☒ Further documents are listed in the continuation of Box C. ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>06 July, 2010 (06.07.10) | Date of mailing of the international search report<br>13 July, 2010 (13.07.10) |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2010/056701 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 6-229778 A (NEC Corp.),<br>19 August 1994 (19.08.1994),<br>entire text; all drawings<br>& DE 69316136 C | 1-29 |
| A | US 2008/0103705 A1 (Hammershmidt),<br>01 May 2008 (01.05.2008),<br>paragraphs [0089] to [0105]; fig. 10 to 11<br>& DE 102006050832 A1 | 1-29 |
| A | CD-ROM of the specification and drawings<br>annexed to the request of Japanese Utility<br>Model Application No. 103789/1991(Laid-open<br>No. 045543/1993)<br>(RKC Instrument Inc.),<br>18 June 1993 (18.06.1993),<br>paragraphs [0002] to [0004]; fig. 5 to 7<br>(Family: none) | 1-29 |
| A | Microfilm of the specification and drawings<br>annexed to the request of Japanese Utility<br>Model Application No. 202427/1983(Laid-open<br>No. 128195/1984)<br>(Fujitsu Ltd.),<br>29 August 1984 (29.08.1984),<br>entire text; all drawings<br>(Family: none) | 1-29 |
| A | JP 2005-164435 A (Yamatake Corp.),<br>23 June 2005 (23.06.2005),<br>paragraph [0040]<br>(Family: none) | 1-29 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5503779 T
- JP 4231838 A

- JP 2009057606 W